# EUROPEAN PATENT APPLICATION

(11) **EP 4 464 760 A1**
(43) Date of publication of application: **20.11.2024**
(21) Application number: 24175801.0
(22) Date of filing: 14.05.2024
(51) Int. Cl.: C09K 11/06, H10K 50/11, H10K 85/60, H10K 101/10

(54) **ORGANIC COMPOUNDS AND ORGANIC LIGHT-EMITTING DEVICE COMPRISING THE SAME**

(30) Priority: 16.05.2023 KR 20230063058; 08.05.2024 KR 20240060426
(71) Applicant: SFC Co., Ltd., Cheongju-si, Chungcheongbuk-do 28122 (KR)
(72) Inventor: KIM, Ji-yung, 28122 Chungcheongbuk-do (KR); KIM, Si-in, 28122 Chungcheongbuk-do (KR); KIM, Kyeong-hyeon, 28122 Chungcheongbuk-do (KR); JANG, Hyuk-woo, 28122 Chungcheongbuk-do (KR); CHOI, Do-yeong, 28122 Chungcheongbuk-do (KR); PARK, Seo-youn, 28122 Chungcheongbuk-do (KR); CHOI, Yeon-jae, 28122 Chungcheongbuk-do (KR); KIM, Kyeong-wan, 28122 Chungcheongbuk-do (KR); LEE, Se-jin, 28122 Chungcheongbuk-do (KR)
(74) Representative: Grosse, Felix Christopher

(57) **Abstract**

Disclosed is an organic compound represented by Formula 1:

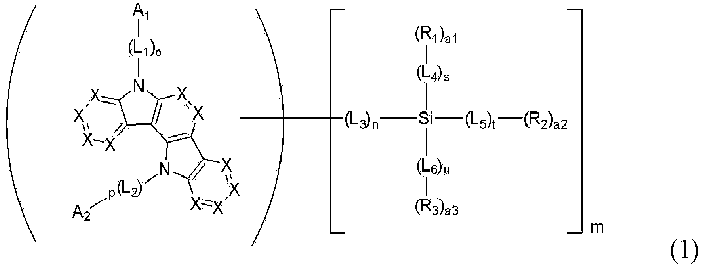

Also disclosed is an organic light emitting device including a light emitting layer employing the organic compound as a host. The use of the organic compound enables low voltage driving of the organic light emitting device and ensures significantly long lifetime and improved luminous efficiency of the device.

## Description

### BACKGROUND OF THE INVENTION

### 1. Field of the Invention

The present invention relates to an organic compound employed in a light emitting layer of an organic light emitting device and an organic light emitting device including the organic compound.

### 2. Description of the Related Art

Organic light emitting devices are self-luminous devices in which electrons injected from an electron injecting electrode (cathode) recombine with holes injected from a hole injecting electrode (anode) in a light emitting layer to form excitons, which emit light while releasing energy. Such organic light emitting devices have the advantages of low driving voltage, high luminance, large viewing angle, and short response time and can be applied to full-color light emitting flat panel displays. Due to these advantages, organic light emitting devices have received attention as next-generation light sources.

The above characteristics of organic light emitting devices are achieved by structural optimization of organic layers of the devices and are supported by stable and efficient materials for the organic layers, such as hole injecting materials, hole transport materials, hole blocking materials, light emitting materials, electron transport materials, electron injecting materials, and electron blocking materials. However, more research still needs to be done to develop structurally optimized structures of organic layers for organic light emitting devices and stable and efficient materials for organic layers of organic light emitting devices.

Particularly, obtaining maximum efficiency in a light emitting layer requires an appropriate combination of energy band gaps of a host and a dopant such that holes and electrons migrate to the dopant through stable electrochemical paths to form excitons.

### SUMMARY OF THE INVENTION

Therefore, the present invention is intended to provide a host material with a specific structure for a light emitting layer and an organic light emitting device including the host material that can be driven at low voltage and has significantly long lifetime and improved luminous efficiency.

One aspect of the present invention provides an organic compound represented by Formula 1:
(1) The specific structure of Formula 1, definitions of the substituents in Formula 1, and specific compounds that can be represented by Formula 1 are described below.

A further aspect of the present invention provides an organic light emitting device including the organic compound as a host for a light emitting layer.

The organic compound of the present invention has a structure in which specific silyl moieties are introduced to a specific indolocarbazole-derived skeleton. The organic light emitting device of the present invention includes a light emitting layer employing the organic compound as a host. The use of the organic compound enables low voltage driving of the organic light emitting device and ensures significantly long lifetime and improved luminous efficiency of the device. Due to these advantages, the long-lasting and highly efficient organic light emitting device of the present invention can find useful applications in not only lighting systems but also a variety of displays, including flat panel displays, flexible displays, wearable displays, displays for virtual reality, and displays for augmented reality.

### DETAILED DESCRIPTION OF THE INVENTION

The present invention will now be described in more detail.

One aspect of the present invention is directed to an organic compound represented by Formula 1: 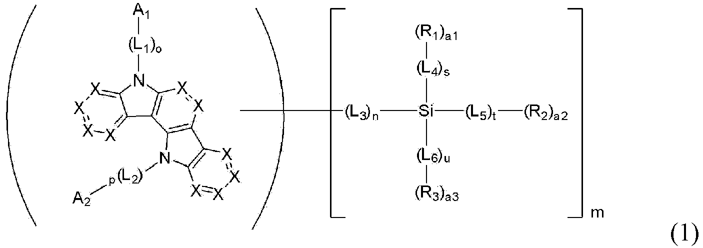 wherein the moieties X are the same as or different from each other and are each independently N or CR, the groups R are the same as or different from each other and are each independently selected from hydrogen, deuterium, substituted or unsubstituted C₁-C₃₀ alkyl, substituted or unsubstituted C₆-C₅₀ aryl, substituted or unsubstituted C₂-C₅₀ heteroaryl, and cyclic groups in which a substituted or unsubstituted C₃-C₃₀ aliphatic ring and a C₅-C₃₀ aromatic ring are fused together, A₁ and A₂ are the same as or different from each other and are each independently selected from substituted or unsubstituted C₆-C₅₀ aryl, substituted or unsubstituted C₂-C₅₀ heteroaryl, and cyclic groups in which a substituted or unsubstituted C₃-C₃₀ aliphatic ring and a C₅-C₃₀ aromatic ring are fused together, R₁ to R₃ are the same as or different from each other and are each independently selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₅₀ cycloalkyl, substituted or unsubstituted C₂-C₅₀ heterocycloalkyl, substituted or unsubstituted C₂-C₅₀ heteroaryl, and cyclic groups in which a substituted or unsubstituted C₃-C₃₀ aliphatic ring and a C₅-C₃₀ aromatic ring are fused together, L₁ to L₆ are the same as or different from each other and each independently represent a single bond or are each independently selected from substituted or unsubstituted C₆-C₃₀ arylene, substituted or unsubstituted C₂-C₃₀ heteroarylene, and divalent cyclic groups in which a substituted or unsubstituted C₃-C₂₄ aliphatic ring and a C₅-C₂₄ aromatic ring are fused together, a₁ to a₃ are integers from 1 to 3, provided that when a₁ to a₃ are integers greater than or equal to 2, the groups R₁ to R₃ are the same as or different from each other, respectively, each of n, o, p, s, t, and u is an integer of 1 or 2, provided that when n, o, p, s, t, and u are integers greater than or equal to 2, L₁ to L₆ are the same as or different from each other, respectively, m is an integer from 1 to 4, provided that when m is an integer greater than or equal to 2, the bracketed structures are the same as or different from each other, with the proviso that adjacent ones of the groups R are optionally linked to each other to form an alicyclic or aromatic monocyclic or polycyclic ring and at least one of A₁, A₂, and the moieties X is optionally linked to L₃ in the bracketed structure.

The term "substituted" in the definitions of X, A₁, A₂, R₁ to R₃, and L₁ to L₆ in Formula 1 indicates substitution with one or more substituents selected from deuterium, C₁-C₂₄ alkyl, C₁-C₂₄ haloalkyl, C₂-C₂₄ alkenyl, C₂-C₂₄ alkynyl, C₃-C₃₀ cycloalkyl, C₁-C₂₄ heteroalkyl, C₆-C₃₀ aryl, C₇-C₃₀ arylalkyl, C₇-C₃₀ alkylaryl, C₂-C₃₀ heteroaryl, C₂-C₃₀ heteroarylalkyl, C₃-C₃₀ alkylheteroaryl, cyclic groups in which a substituted or unsubstituted C₃-C₂₄ aliphatic ring and a C₅-C₂₄ aromatic ring are fused together, C₁-C₂₄ alkoxy, C₁-C₃₀ amine, C₁-C₃₀ silyl, C₁-C₃₀ germanium, C₆-C₂₄ aryloxy, C₆-C₂₄ arylthionyl, cyano, halogen, hydroxyl, and nitro, or a combination thereof. When substituted with two or more substituents, the substituents may be identical to or different from each other. The term "unsubstituted" in the same definition indicates having no substituent. One or more hydrogen atoms in each of the substituents are optionally replaced by deuterium atoms.

According to one embodiment of the present invention, A₁ and A₂ may be the same as or different from each other and may be each independently substituted or unsubstituted C₆-C₃₀ aryl.

According to one embodiment of the present invention, m may be an integer of 1 and L₃ may form a single bond with at least one of A₁ and A₂.

According to one embodiment of the present invention, R₁ to R₃ may be the same as or different from each other and may be each independently substituted or unsubstituted C₆-C₁₄ aryl.

According to one embodiment of the present invention, the organic compound represented by Formula 1 may be deuterated.

A further aspect of the present invention is directed to an organic light emitting device including a first electrode, a second electrode, and one or more organic layers interposed between the first and second electrodes wherein one of the organic layers is preferably a light emitting layer including a host and a dopant and the host includes the compound represented by Formula 1:

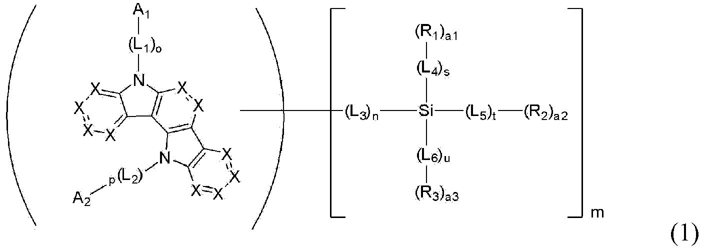

The light emitting layer may further include a dopant material. In this case, the total content of the dopants in the light emitting layer is typically in the range of about 0.01 to about 20 parts by weight, based on about 100 parts by weight of the hosts but is not limited to this range.

The light emitting layer may further include one or more other dopant materials and one or more other hosts. Thus, two or more different dopant materials and two or more different host materials may be mixed or stacked in the light emitting layer.

According to one embodiment of the present invention, the light emitting layer as one of the organic layers interposed between the first and second electrodes may include one or more host compounds other than the compound represented by Formula 1 wherein the two or more host compounds may be mixed or stacked in the light emitting layer.

In this embodiment, the additional host compound may be a compound having an electron acceptor moiety. The mixing and stacking of the additional host compound with the compound represented by Formula 1 having a fused carbazole moiety as an electron donor moiety increases the HOMO/LUMO levels of hole injection and electron injection barriers, and as a result, the recombination zone is limited to the interface of the two hosts, leading to minimal current loss. Due to this advantage, the organic light emitting device has high efficiency and long lifetime.

The compound having an electron acceptor moiety refers to a compound that has a moiety by which electrons from the outside are easily accepted. The compound having an electron acceptor moiety may be an azine compound that has an aromatic heterocyclic moiety containing nitrogen in the molecule, such as pyridine, pyrimidine or triazine, or a cyano (-CN)-substituted compound. The compound having an electron acceptor moiety is preferably a compound that has a heteroaryl group containing one to three nitrogen (N) atoms in the molecule or an aryl group containing one to three cyano groups (-CN) in the molecule.

More specifically, the hosts employed in the light emitting layer of the organic light emitting device according to the present invention compound may be the compound represented by Formula 1 and an organic compound represented by Formula 2 or 3: 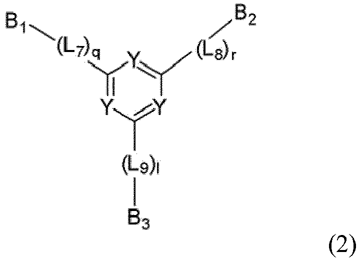 wherein the moieties Y are the same as or different from each other and are each independently N or CR₁₁, with the proviso that at least one of the moieties Y is N, the groups R₁₁ are the same as or different from each other and are each independently selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₅₀ cycloalkyl, substituted or unsubstituted C₂-C₅₀ heterocycloalkyl, substituted or unsubstituted C₂-C₅₀ heteroaryl, and cyclic groups in which a substituted or unsubstituted C₃-C₃₀ aliphatic ring and a C₅-C₃₀ aromatic ring are fused together, L₇ to L₉ are the same as or different from each other and each independently represent a single bond or are each independently selected from substituted or unsubstituted C₆-C₃₀ arylene, substituted or unsubstituted C₂-C₃₀ heteroarylene, and divalent cyclic groups in which a substituted or unsubstituted C₃-C₂₄ aliphatic ring and a C₅-C₂₄ aromatic ring are fused together, B₁ to B₃ are the same as or different from each other and are each independently selected from substituted or unsubstituted C₆-C₅₀ aryl, substituted or unsubstituted C₂-C₅₀ heteroaryl, and cyclic groups in which a substituted or unsubstituted C₃-C₃₀ aliphatic ring and a C₅-C₃₀ aromatic ring are fused together, substituted or unsubstituted C₁-C₃₀ amine, substituted or unsubstituted C₁-C₃₀ silyl, and substituted or unsubstituted C₁-C₃₀ germanium, and q, r, and l are integers of 1 or 2, provided that when q, r, and l are integers greater than or equal to 2, L₇ to L₉ are the same as or different from each other, respectively, 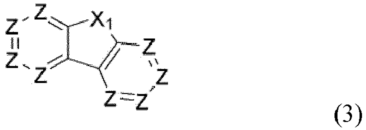 wherein the moieties Z are the same as or different from each other and are each independently N or CR₁₂, with the proviso that at least one of the moieties Z is N, X₁ is O, S, NR₁₃, CR₁₄R₁₅, SiR₁₆R₁₇ or GeR₁₈R₁₉, R₁₂ to R₁₉ are the same as or different from each other and are each independently selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₅₀ cycloalkyl, substituted or unsubstituted C₂-C₅₀ heterocycloalkyl, substituted or unsubstituted C₂-C₅₀ heteroaryl, and cyclic groups in which a substituted or unsubstituted C₃-C₃₀ aliphatic ring and a C₅-C₃₀ aromatic ring are fused together, with the proviso that adjacent ones of the groups R₁₂ are optionally linked to each other to form an alicyclic or aromatic monocyclic or polycyclic ring, R₁₄ and R₁₅ are optionally linked to each other to form an alicyclic or aromatic monocyclic or polycyclic ring, R₁₆ and R₁₇ are optionally linked to each other to form an alicyclic or aromatic monocyclic or polycyclic ring, and R₁₈ and R₁₉ are optionally linked to each other to form an alicyclic or aromatic monocyclic or polycyclic ring.

The compound represented by Formula 1 may be used in admixture with the organic compound represented by Formula 2 or 3. Alternatively, the compound represented by Formula 2 or 3 may be stacked on or under a layer including the compound represented by Formula 1.

The term "substituted" in the definitions of Y, Z, X₁, L₇ to L₉, and B₁ to B₃ in Formula 2 and X₁ and Z in Formula 3 indicates substitution with one or more substituents selected from deuterium, C₁-C₂₄ alkyl, C₁-C₂₄ haloalkyl, C₂-C₂₄ alkenyl, C₂-C₂₄ alkynyl, C₃-C₃₀ cycloalkyl, C₁-C₂₄ heteroalkyl, C₆-C₃₀ aryl, C₇-C₃₀ arylalkyl, C₇-C₃₀ alkylaryl, C₂-C₃₀ heteroaryl, C₂-C₃₀ heteroarylalkyl, cyclic groups in which a substituted or unsubstituted C₃-C₂₄ aliphatic ring and a C₅-C₂₄ aromatic ring are fused together, C₁-C₂₄ alkoxy, C₁-C₃₀ amine, C₁-C₃₀ silyl, C₁-C₃₀ germanium, C₆-C₂₄ aryloxy, C₆-C₂₄ arylthionyl, cyano, halogen, hydroxyl, and nitro, or a combination thereof. When substituted with two or more substituents, the substituents may be identical to or different from each other. The term "unsubstituted" in the same definition indicates having no substituent. One or more hydrogen atoms in each of the substituents are optionally replaced by deuterium atoms.

The dopant compounds employed in the light emitting layer of the organic light emitting device according to the present invention are not fluorescent dopant materials that are transferred only to singlet states based on Forster energy transfer in traditional host-dopant systems but phosphorescent dopant materials that are transferred to both singlet and triplet states irrespective of whether their state based on Dexter energy transfer. The phosphorescent dopant materials are metal complexes containing at least one metal selected from Ir, Pt, Os, Ti, Zr, Hf, Eu, Tb, Tm, Fe, Co, Ni, Ru, Rh, Re, and Pd but are not particularly limited thereto as long as they emit light from triplet excitons. The metal is preferably selected from Ir, Pt, and Pd and specific examples of the metal complexes include, but are not limited to, Ir(ppy)₃, Ir(ppy)₂acac, Ir(Bt)₂acac, Ir(MDQ)₂acac, Ir(mppy)₃, Ir(piq)₃, Ir(piq)₂acac, Ir(pq)₂acac, Ir(mpp)₂acac, F₂Irpic, (F₂ppy)₂Ir(tmd), Ir(ppy)₂tmd, Ir(pmi)₃, Ir(pmb)₃, FCNIr, FCNIrpic, FIr₆, FIrN₄, FIrpic, PtOEP, Ir(chpy)₃, P0-01(C₃₁H₂₃IrN₂O₂S₂), Ir(ppz)₃, Ir(dfppz)₃, PtNON, Pt-10, and Pt-11.

According to one embodiment of the present invention, the dopants may include at least one organometallic compound.

The organometallic compound may be mixed or stacked with one or more other dopants. One of the additional dopants may be a polycyclic compound represented by Formula 4: 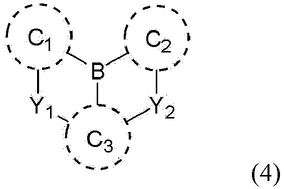 wherein Y₁ and Y₂ are the same as or different from each other and are each independently selected from O, S, NR₃₁, CR₃₂R₃₃, SiR₃₄R₃₅, and GeR₃₆R₃₇, C₁ to C₃ are the same as or different from each other and are each independently selected from substituted or unsubstituted C₆-C₃₀ aromatic hydrocarbon rings, substituted or unsubstituted C₃-C₃₀ aliphatic hydrocarbon rings, substituted or unsubstituted C₂-C₃₀ aromatic heterocyclic rings, substituted or unsubstituted C₂-C₃₀ aliphatic heterocyclic rings, and cyclic groups in which a substituted or unsubstituted C₃-C₂₄ aliphatic ring and a C₅-C₂₄ aromatic ring are fused together, R₃₁ to R₃₇ are the same as or different from each other and are each independently selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₅₀ cycloalkyl, substituted or unsubstituted C₂-C₅₀ heterocycloalkyl, substituted or unsubstituted C₂-C₅₀ heteroaryl, cyclic groups in which a substituted or unsubstituted C₃-C₃₀ aliphatic ring and a C₅-C₃₀ aromatic ring are fused together, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, substituted or unsubstituted germanium, nitro, cyano, and halogen, with the proviso that each of R₃₁ to R₃₇ is optionally linked to one or more of the C₁ to C₃ rings to form an alicyclic or aromatic monocyclic or polycyclic ring, R₃₂ and R₃₃ are optionally linked to each other to form an alicyclic or aromatic monocyclic or polycyclic ring, R₃₄ and R₃₅ are optionally linked to each other to form an alicyclic or aromatic monocyclic or polycyclic ring, and R₃₆ and R₃₇ are optionally linked to each other to form an alicyclic or aromatic monocyclic or polycyclic ring.

The term "substituted" in the definitions of Y₁, Y₂, and C₁ to C₃ in Formula 4 indicates substitution with one or more substituents selected from deuterium, C₁-C₂₄ alkyl, C₂-C₂₄ alkenyl, C₂-C₂₄ alkynyl, C₃-C₃₀ cycloalkyl, C₁-C₂₄ heteroalkyl, C₆-C₃₀ aryl, C₇-C₃₀ arylalkyl, C₇-C₃₀ alkylaryl, C₂-C₃₀ heteroaryl, C₂-C₃₀ heteroarylalkyl, cyclic groups in which a substituted or unsubstituted C₃-C₂₄ aliphatic ring and a C₅-C₂₄ aromatic ring are fused together, C₁-C₂₄ alkoxy, C₁-C₃₀ amine, C₁-C₃₀ silyl, C₁-C₃₀ germanium, C₆-C₂₄ aryloxy, C₆-C₂₄ arythionyl, cyano, halogen, hydroxyl, and nitro, or a combination thereof. When substituted with two or more substituents, the substituents may be identical to or different from each other. The term "unsubstituted" in the same definition indicates having no substituent. One or more hydrogen atoms in each of the substituents are optionally replaced by deuterium atoms.

Accordingly, according to one embodiment of the present invention, the light emitting layer of the organic light emitting device may include a first host, a second host, an organometallic compound, and the polycyclic compound (thermally activated delayed boron-based fluorescent material) of Formula 4.

The organometallic compound functions as a sensitizer and the polycyclic compound functions as a light emitting dopant. The sensitizer compound receives excitons from the first host and the second host and transfer the excitons to the light emitting dopant.

Accordingly, excitons are transferred from the sensitizer to the light emitting dopant compound through the Dexter energy transfer (DET) or Forster resonance transfer (FRET) mechanism, and the exciton energy delivered to the light emitting dopant compound is transferred to the ground state. In this process, the energy is emitted as light. The excitons can be transferred from the first and second hosts to the sensitizer through the FRET or DET mechanism.

In conclusion, the FRET or DET mechanism facilitates energy transfer between the sensitizer and the light emitting dopant and suppresses triplet-triplet annihilation, ensuring high efficiency of the organic light emitting device.

Forster energy transfer from the triplet of the phosphorescence sensitizer to the singlet of the polycyclic compound (thermally activated delayed boron-based fluorescent material) represented by Formula 4, contributes to a reduction in the number of long-lived triplet excitons involved in the degradation of the device, ensuring long lifetime of the device.

In addition, the high molar extinction coefficient of the polycyclic compound ensures fast fluorescence resonance energy transfer from the phosphorescence sensitizer to the fluorescent material and the multiple resonance effect of the polycyclic compound narrows the emission spectrum to increase the color purity of the device, achieving improved efficiency and lifetime of the device.rrr

The organic layers of the organic light emitting device according to the present invention may form a monolayer structure. Alternatively, the organic layers may be stacked together to form a multilayer structure. For example, the organic layers may have a structure including a hole injecting layer, a hole transport layer, a hole blocking layer, a light emitting layer, an electron blocking layer, an electron transport layer, and an electron injecting layer but are not limited to this structure. The number of the organic layers is not limited and may be increased or decreased. Preferred structures of the organic layers of the organic light emitting device according to the present invention will be explained in more detail in the Examples section that follows.

In the "substituted or unsubstituted C₁-C₃₀ alkyl", "substituted or unsubstituted C₆-C₅₀ aryl", etc., the number of carbon atoms in the alkyl or aryl group indicates the number of carbon atoms constituting the unsubstituted alkyl or aryl moiety without considering the number of carbon atoms in the substituent(s). For example, a phenyl group substituted with a butyl group at the para-position corresponds to a C₆ aryl group substituted with a C₄ butyl group.

As used herein, the expression "optionally linked to each other or an adjacent group to form a ring" means that the corresponding adjacent substituents are bonded to each other or each of the corresponding substituents is bonded to an adjacent group to form a substituted or unsubstituted alicyclic or aromatic ring. The term "adjacent group" may mean a substituent on an atom directly attached to an atom substituted with the corresponding substituent, a substituent disposed sterically closest to the corresponding substituent or another substituent on an atom substituted with the corresponding substituent. For example, two substituents substituted at the ortho position of a benzene ring or two substituents on the same carbon in an aliphatic ring may be considered "adjacent" to each other. Optionally, the paired substituents each lose one hydrogen radical and are linked to each other to form a ring. The carbon atoms in the resulting alicyclic, aromatic mono- or polycyclic ring may be replaced by one or more heteroatoms such as O, S, N, P, Si, and Ge.

In the present invention, the alkyl groups may be straight or branched. Specific examples of the alkyl groups include, but are not limited to, methyl, ethyl, propyl, n-propyl, isopropyl, butyl, n-butyl, isobutyl, tert-butyl, sec-butyl, 1-methylbutyl, 1-ethylbutyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethylpropyl, 1,1-dimethylpropyl, isohexyl, 2-methylpentyl, 4-methylhexyl, and 5-methylhexyl groups.

In the present invention, specific examples of the arylalkyl groups include, but are not limited to, phenylmethyl(benzyl), phenylethyl, phenylpropyl, naphthylmethyl, and naphthylethyl.

In the present invention, specific examples of the alkylaryl groups include, but are not limited to, tolyl, xylenyl, dimethylnaphthyl, t-butylphenyl, t-butylnaphthyl, and t-butylphenanthryl.

The alkenyl group is intended to include straight and branched ones and may be optionally substituted with one or more other substituents. The alkenyl group may be specifically a vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, stilbenyl or styrenyl group but is not limited thereto.

The alkynyl group is intended to include straight and branched ones and may be optionally substituted with one or more other substituents. The alkynyl group may be, for example, ethynyl or 2-propynyl but is not limited thereto.

The cycloalkenyl group is a non-aromatic cyclic unsaturated hydrocarbon group having one or more carbon-carbon double bonds. The cycloalkenyl group may be, for example, cyclopropenyl, cyclobutenyl, cyclopentenyl, cyclohexenyl, cycloheptenyl, 1,3-cyclohexadienyl, 1,4-cyclohexadienyl, 2,4-cycloheptadienyl or 1,5-cyclooctadienyl but is not limited thereto.

The aromatic hydrocarbon rings or aryl groups may be monocyclic or polycyclic ones. As used herein, the term "polycyclic" means that the aromatic hydrocarbon ring may be directly attached or fused to one or more other cyclic groups. The other cyclic groups may be aromatic hydrocarbon rings and other examples thereof include aliphatic heterocyclic rings, aliphatic hydrocarbon rings, and aromatic heterocyclic rings. Examples of the monocyclic aryl groups include, but are not limited to, phenyl, biphenyl, and terphenyl. Examples of the polycyclic aryl groups include naphthyl, anthracenyl, phenanthrenyl, pyrenyl, perylenyl, tetracenyl, chrysenyl, fluorenyl, acenaphathcenyl, triphenylene, and fluoranthrene groups but the scope of the present invention is not limited thereto.

The aromatic heterocyclic rings or heteroaryl groups refer to aromatic groups containing one or more heteroatoms such as O, S, N, P, Si, and Ge. Examples of the aromatic heterocyclic rings or heteroaryl groups include, but are not limited to, thiophene, furan, pyrrole, imidazole, thiazole, oxazole, oxadiazole, triazole, pyridyl, bipyridyl, pyrimidyl, triazine, triazole, acridyl, pyridazine, pyrazinyl, quinolinyl, quinazoline, quinoxalinyl, phthalazinyl, pyridopyrimidinyl, pyridopyrazinyl, pyrazinopyrazinyl, isoquinoline, indole, carbazole, benzoxazole, benzimidazole, benzothiazole, benzocarbazole, benzothiophene, dibenzothiophene, benzofuranyl, dibenzofuranyl, phenanthroline, thiazolyl, isoxazolyl, oxadiazolyl, thiadiazolyl, benzothiazolyl, and phenothiazinyl groups.

The aliphatic hydrocarbon rings or cycloalkyl groups refer to non-aromatic rings consisting only of carbon and hydrogen atoms. The aliphatic hydrocarbon ring is intended to include monocyclic and polycyclic ones and may be optionally substituted with one or more other substituents. As used herein, the term "polycyclic" means that the aliphatic hydrocarbon ring may be directly attached or fused to one or more other cyclic groups. The other cyclic groups may be aliphatic hydrocarbon rings and other examples thereof include aliphatic heterocyclic rings, aromatic hydrocarbon rings, and aromatic heterocyclic rings. Specific examples of the aliphatic hydrocarbon rings include, but are not limited to, cycloalkyl groups such as cyclopropyl, cyclobutyl, cyclopentyl, adamantyl, bicycloheptanyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, and cyclooctyl, cycloalkanes such as cyclohexane and cyclopentane, and cycloalkenes such as cyclohexene and cyclobutene.

The aliphatic heterocyclic rings or heterocycloalkyl groups refer to aliphatic rings containing one or more heteroatoms such as O, S, Se, N, Si, and Ge. The aliphatic heterocyclic ring is intended to include monocyclic or polycyclic ones and may be optionally substituted with one or more other substituents. As used herein, the term "polycyclic" means that the aliphatic heterocyclic ring such as heterocycloalkyl or heterocycloalkane may be directly attached or fused to one or more other cyclic groups. The other cyclic groups may be aliphatic heterocyclic rings and other examples thereof include aliphatic hydrocarbon rings, aromatic hydrocarbon rings, and aromatic heterocyclic rings.

The cyclic group(s) in which an aliphatic ring and an aromatic ring are fused together refers to a mixed aliphatic-aromatic cyclic group(s) in which two or more rings are linked and fused together and which are overall non-aromatic. More specifically, the cyclic group(s) in which an aliphatic ring and an aromatic ring are fused together may be an aromatic hydrocarbon cyclic group(s) fused with an aliphatic hydrocarbon ring, an aromatic hydrocarbon cyclic group(s) fused with an aliphatic heterocyclic ring, an aromatic heterocyclic group(s) fused with an aliphatic hydrocarbon ring, an aromatic hydrocarbon cyclic group(s) fused with an aliphatic heterocyclic ring, an aliphatic heterocyclic group(s) fused with an aromatic hydrocarbon ring, an aliphatic hydrocarbon cyclic group(s) fused with an aliphatic heterocyclic ring, an aliphatic heterocyclic group(s) fused with an aromatic hydrocarbon ring or an aliphatic heterocyclic group(s) fused with an aromatic heterocyclic ring. Specific examples of the cyclic group(s) in which an aliphatic ring and an aromatic ring are fused together include tetrahydronaphthyl, tetrahydrobenzocycloheptene, tetrahydrophenanthrene, tetrahydroanthracenyl, octahydrotriphenylene, tetrahydrobenzothiophene, tetrahydrobenzofuranyl, tetrahydrocarbazole, and tetrahydroquinoline. The cyclic group(s) in which an aliphatic ring and an aromatic ring are fused together may be interrupted by at least one heteroatom other than carbon. The heteroatom may be, for example, O, S, N, P, Si or Ge.

The alkoxy group may be specifically a methoxy, ethoxy, propoxy, isobutyloxy, sec-butyloxy, pentyloxy, iso-amyloxy or hexyloxy group but is not limited thereto.

The silyl group is intended to include -SiH₃, alkylsilyl, arylsilyl, alkylarylsilyl, arylheteroarylsilyl, and heteroaryl silyl. The arylsilyl refers to a silyl group obtained by substituting one, two or three of the hydrogen atoms in -SiH₃ with aryl groups. The alkylsilyl refers to a silyl group obtained by substituting one, two or three of the hydrogen atoms in -SiH₃ with alkyl groups. The alkylarylsilyl refers to a silyl group obtained by substituting one of the hydrogen atoms in -SiH₃ with an alkyl group and the other two hydrogen atoms with aryl groups or substituting two of the hydrogen atoms in -SiH₃ with alkyl groups and the remaining hydrogen atom with an aryl group. The arylheteroaryl silyl refers to a silyl group obtained by substituting one of the hydrogen atoms in -SiH₃ with an aryl group and the other two hydrogen atoms with heteroaryl groups or substituting two of the hydrogen atoms in -SiH₃ with aryl groups and the remaining hydrogen atom with a heteroaryl group. The heteroarylsilyl refers to a silyl group obtained by substituting one, two or three of the hydrogen atoms in -SiH₃ with heteroaryl groups. The arylsilyl group may be, for example, substituted or unsubstituted monoarylsilyl, substituted or unsubstituted diarylsilyl, or substituted or unsubstituted triarylsilyl. The same applies to the alkylsilyl and heteroarylsilyl groups.

Each of the aryl groups in the aryl silyl, heteroarylsilyl, and arylheteroarylsilyl groups may be a monocyclic or polycyclic one. Each of the heteroaryl groups in the arylsilyl, heteroarylsilyl, and arylheteroarylsilyl groups may be a monocyclic or polycyclic one.

Specific examples of the silyl groups include trimethylsilyl, triethylsilyl, triphenylsilyl, trimethoxysilyl, dimethoxyphenylsilyl, diphenylmethylsilyl, diphenylvinylsilyl, methylcyclobutylsilyl, and dimethylfurylsilyl. One or more of the hydrogen atoms in each of the silyl groups may be substituted with the substituents mentioned in the aryl groups.

The amine group is intended to include -NH₂, alkylamine, arylamine, arylheteroarylamine, and heteroarylamine. The arylamine refers to an amine group obtained by substituting one or two of the hydrogen atoms in -NH₂ with aryl groups. The alkylamine refers to an amine group obtained by substituting one or two of the hydrogen atoms in -NH₂ with alkyl groups. The alkylarylamine refers to an amine group obtained by substituting one of the hydrogen atoms in -NH₂ with an alkyl group and the other hydrogen atom with an aryl group. The arylheteroarylamine refers to an amine group obtained by substituting one of the hydrogen atoms in -NH₂ with an aryl group and the other hydrogen atom with a heteroaryl group. The heteroarylamine refers to an amine group obtained by substituting one or two of the hydrogen atoms in -NH₂ with heteroaryl groups. The arylamine may be, for example, substituted or unsubstituted monoarylamine, substituted or unsubstituted diarylamine, or substituted or unsubstituted triarylamine. The same applies to the alkylamine and heteroarylamine groups.

Each of the aryl groups in the arylamine, heteroarylamine, and arylheteroarylamine groups may be a monocyclic or polycyclic one. Each of the heteroaryl groups in the arylamine, heteroarylamine, and arylheteroarylamine groups may be a monocyclic or polycyclic one.

The germanium group is intended to include -GeH₃, alkylgermanium, aryl germanium, heteroarylgermanium, alkylarylgermanium, alkylheteroarylgermanium, and arylheteroarylgermanium. The definitions of the substituents in the germanium groups follow those described for the silyl groups, except that the silicon (Si) atom in each silyl group is changed to a germanium (Ge) atom.

Specific examples of the germanium groups include trimethylgermane, triethylgermane, triphenylgermane, trimethoxygermane, dimethoxyphenylgermane, diphenylmethylgermane, diphenylvinylgermane, methylcyclobutylgermane, and dimethylfurylgermane. One or more of the hydrogen atoms in each of the germanium groups may be substituted with the substituents mentioned in the aryl groups.

The cycloalkyl, aryl, and heteroaryl groups in the cycloalkyloxy, aryloxy, heteroaryloxy, cycloalkylthioxy, arylthioxy, and heteroarylthioxy groups are the same as those exemplified above. Specific examples of the aryloxy groups include, but are not limited to, phenoxy, p-tolyloxy, m-tolyloxy, 3,5-dimethylphenoxy, 2,4,6-trimethylphenoxy, p-tert-butylphenoxy, 3-biphenyloxy, 4-biphenyloxy, 1-naphthyloxy, 2-naphthyloxy, 4-methyl-1-naphthyloxy, 5-methyl-2-naphthyloxy, 1-anthryloxy, 2-anthryloxy, 9-anthryloxy, 1-phenanthryloxy, 3-phenanthryloxy, and 9-phenanthryloxy groups. Specific examples of the arylthioxy groups include, but are not limited to, phenylthioxy, 2-methylphenylthioxy, and 4-tert-butylphenylthioxy groups.

The halogen group may be, for example, fluorine, chlorine, bromine or iodine.

According to one embodiment of the present invention, the compound represented by Formula 1 may be selected from the following compounds:

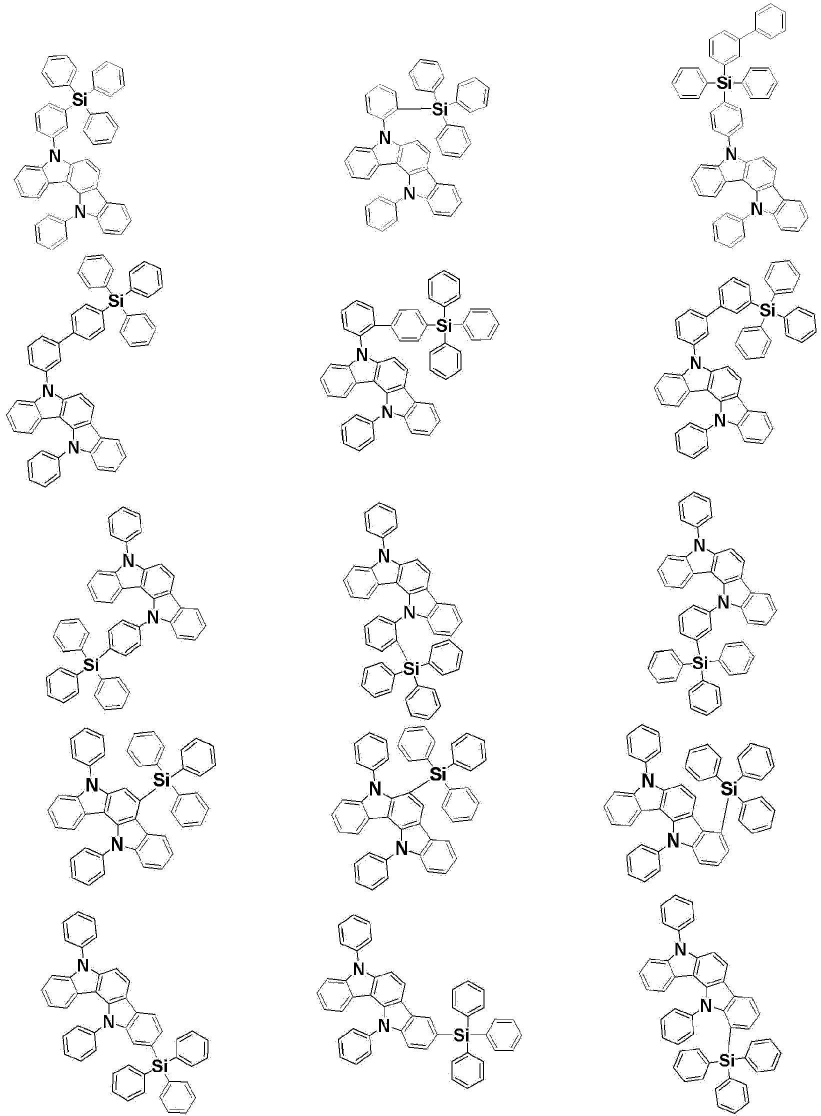

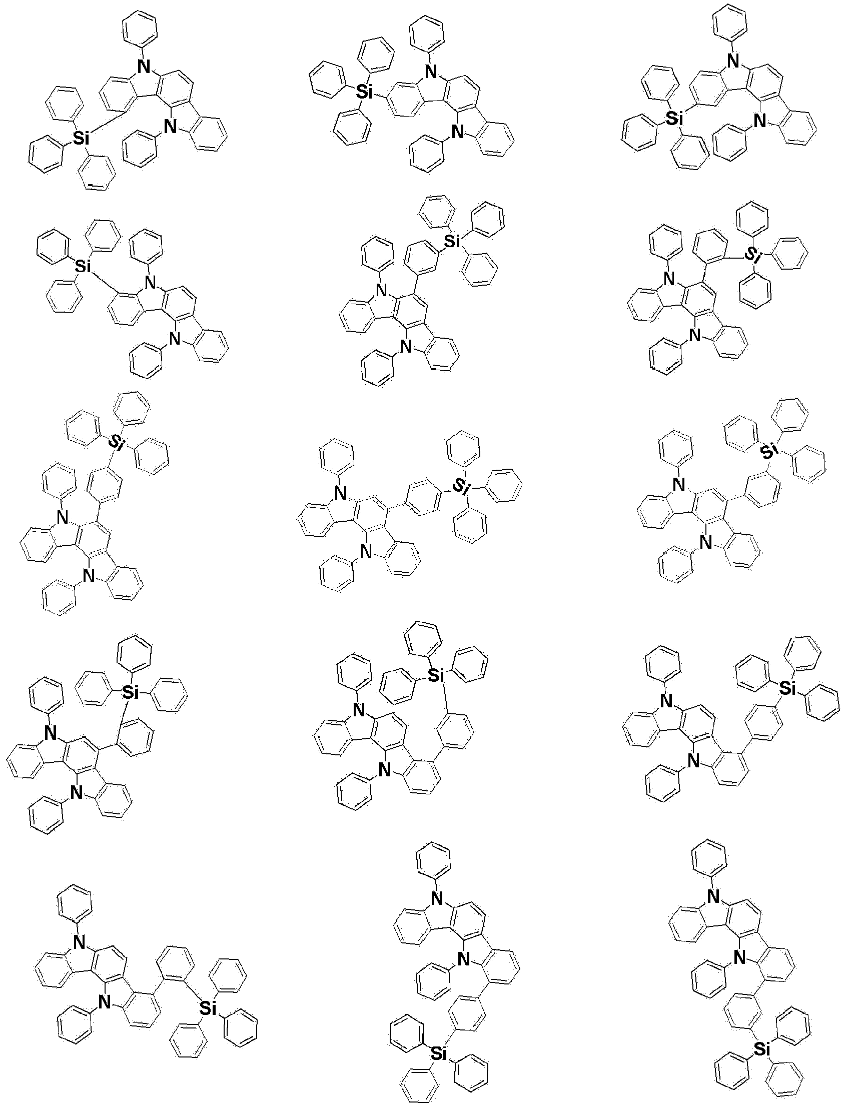

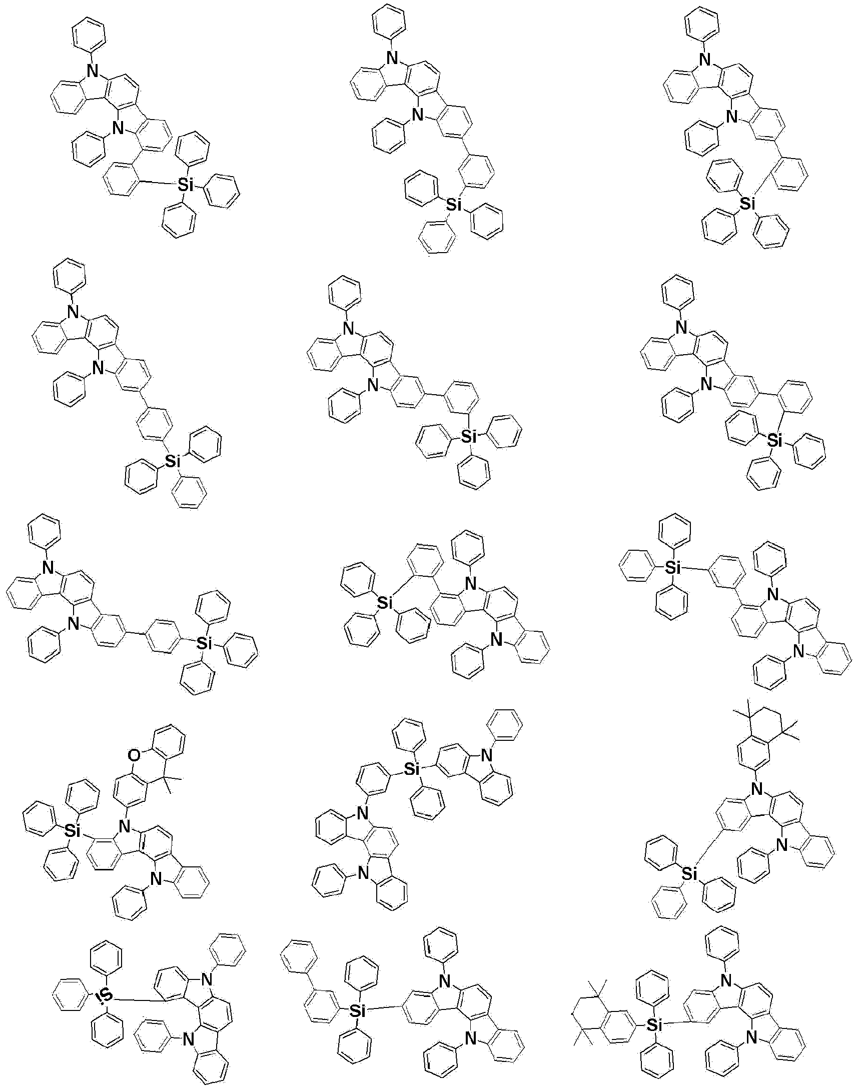

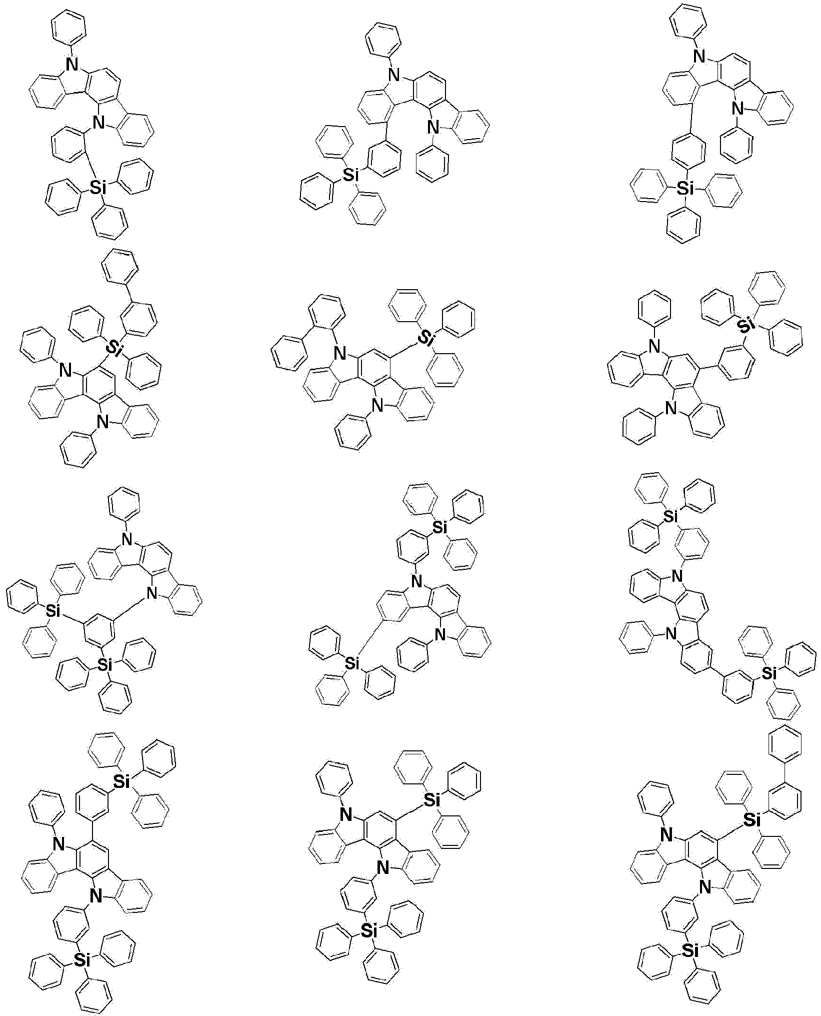

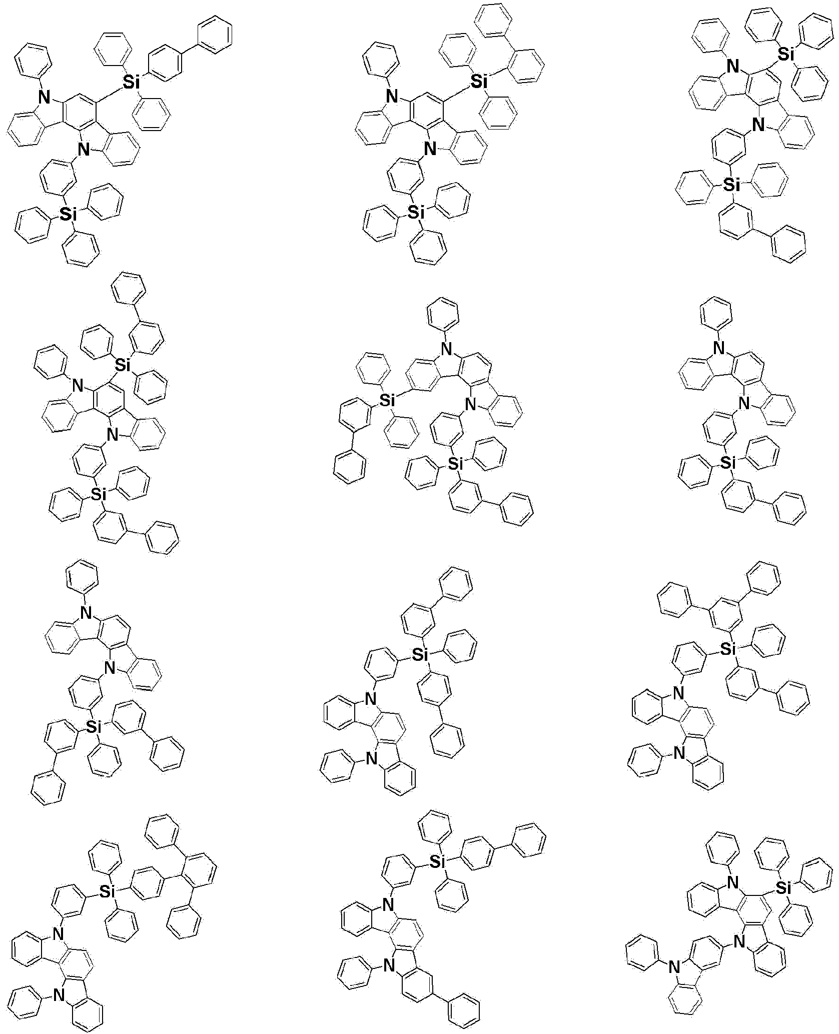

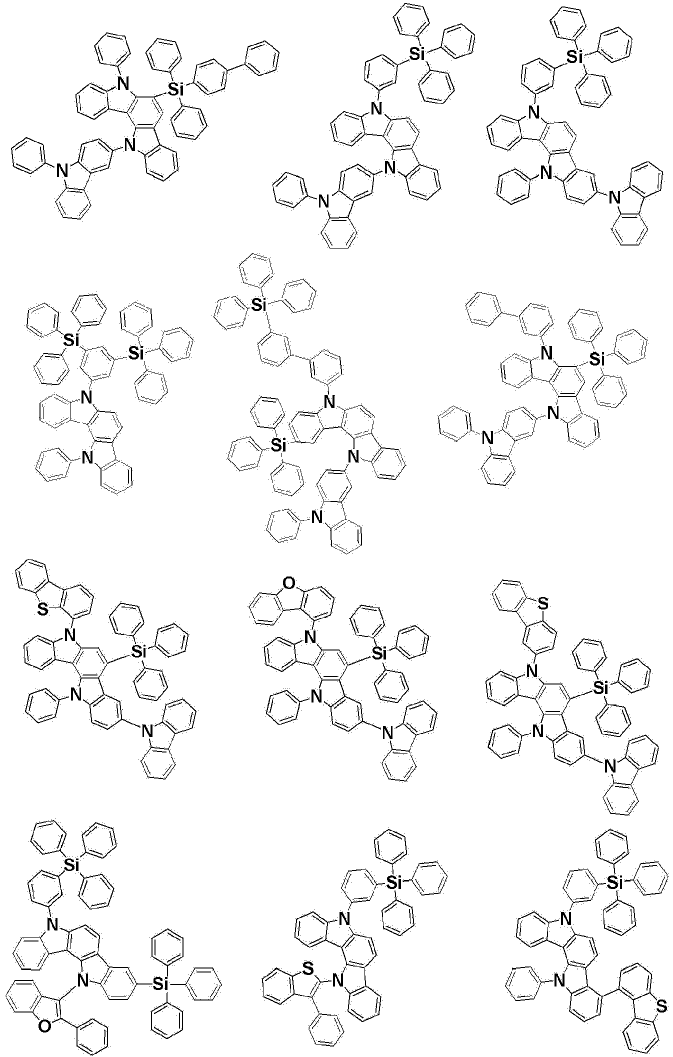

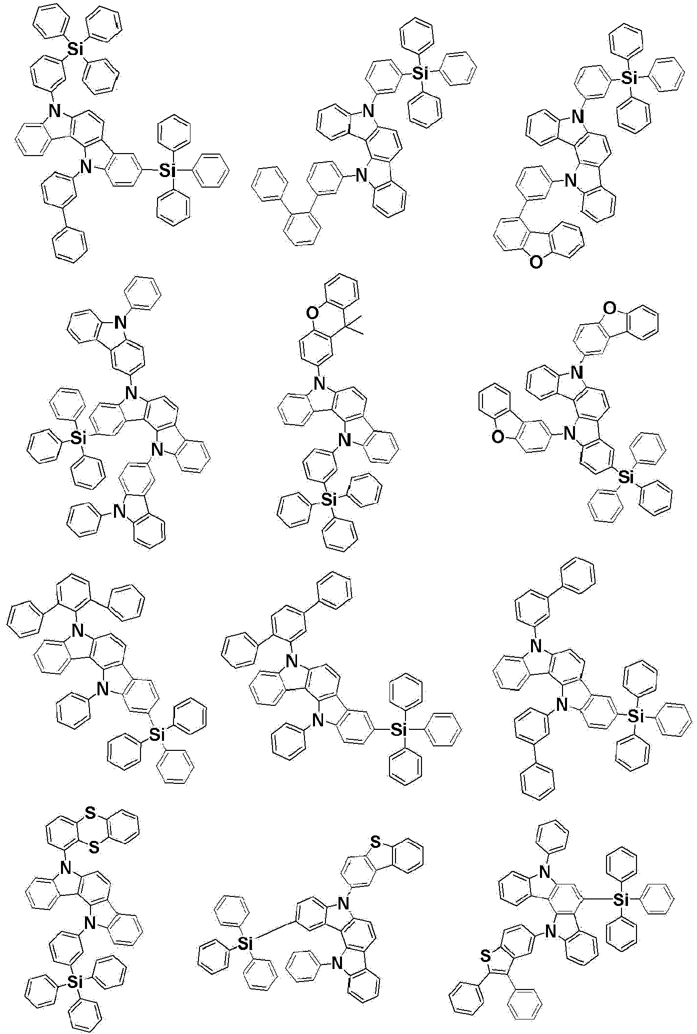

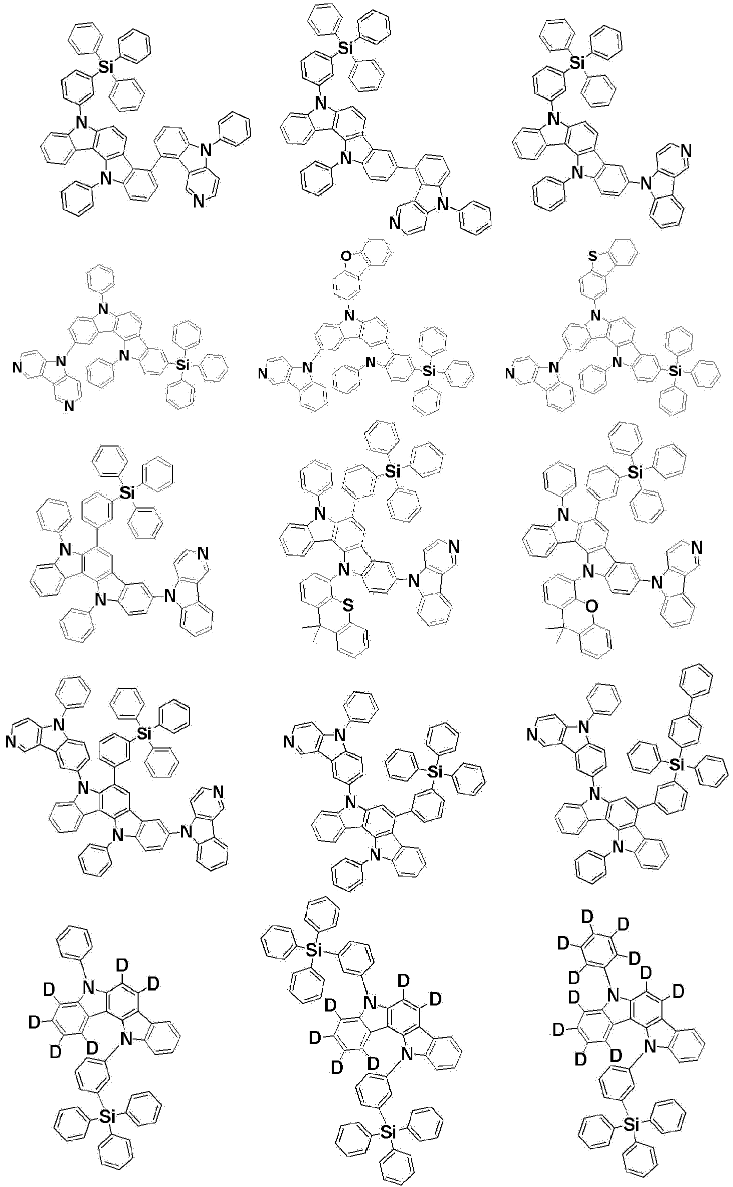

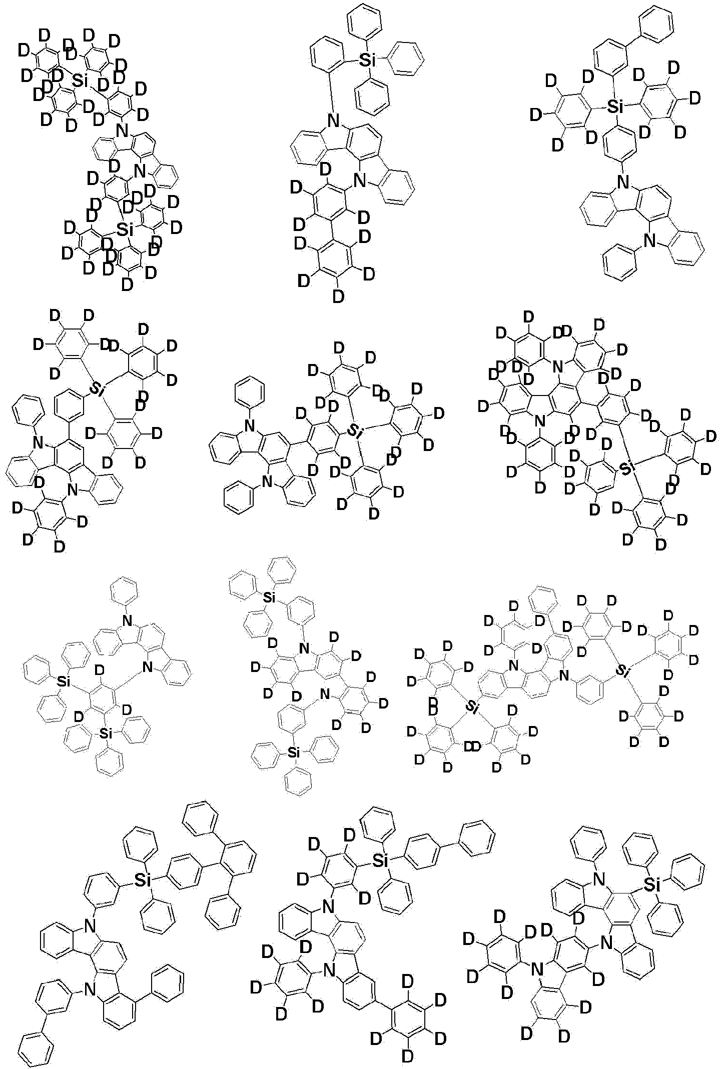

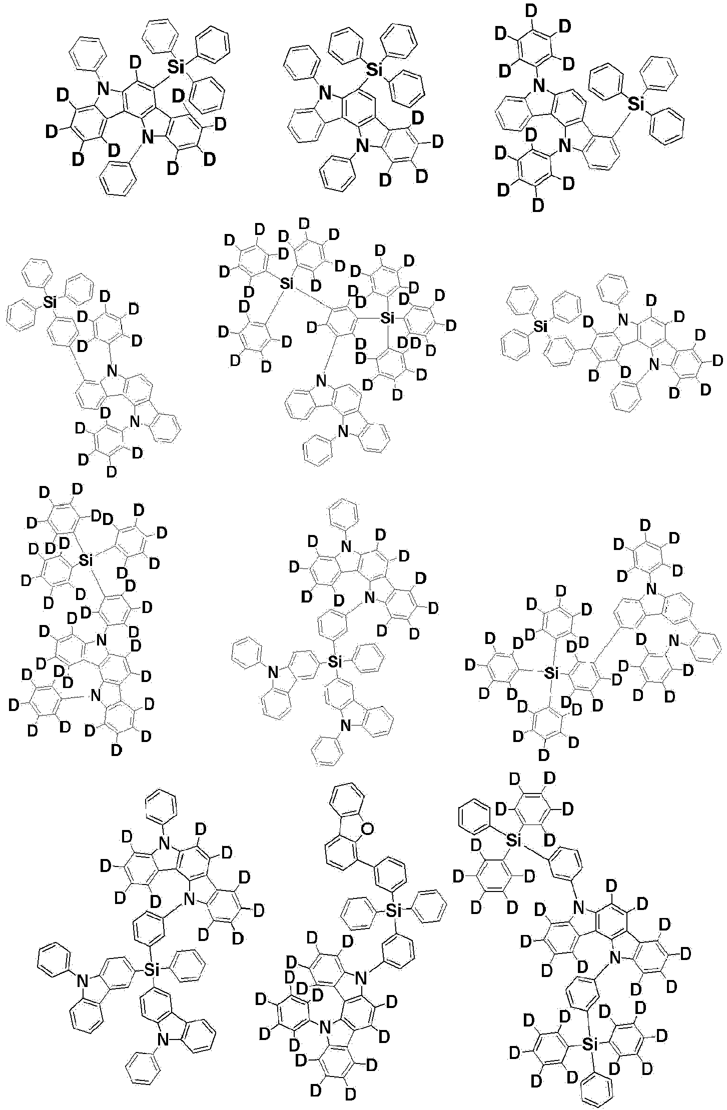

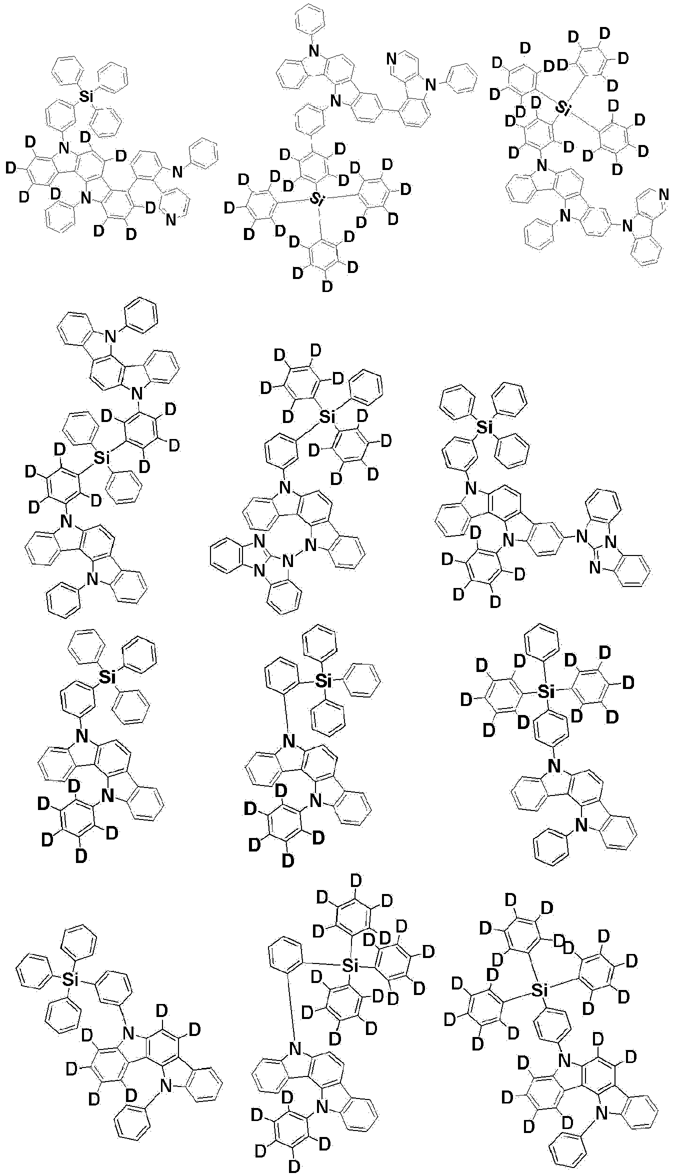

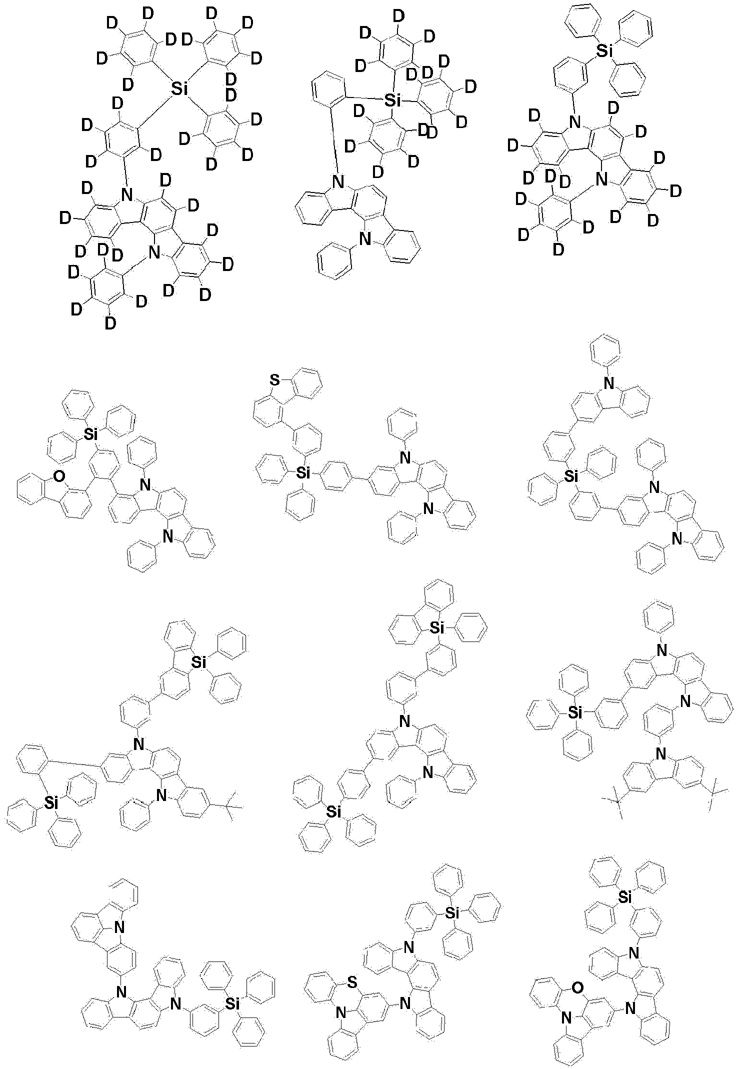

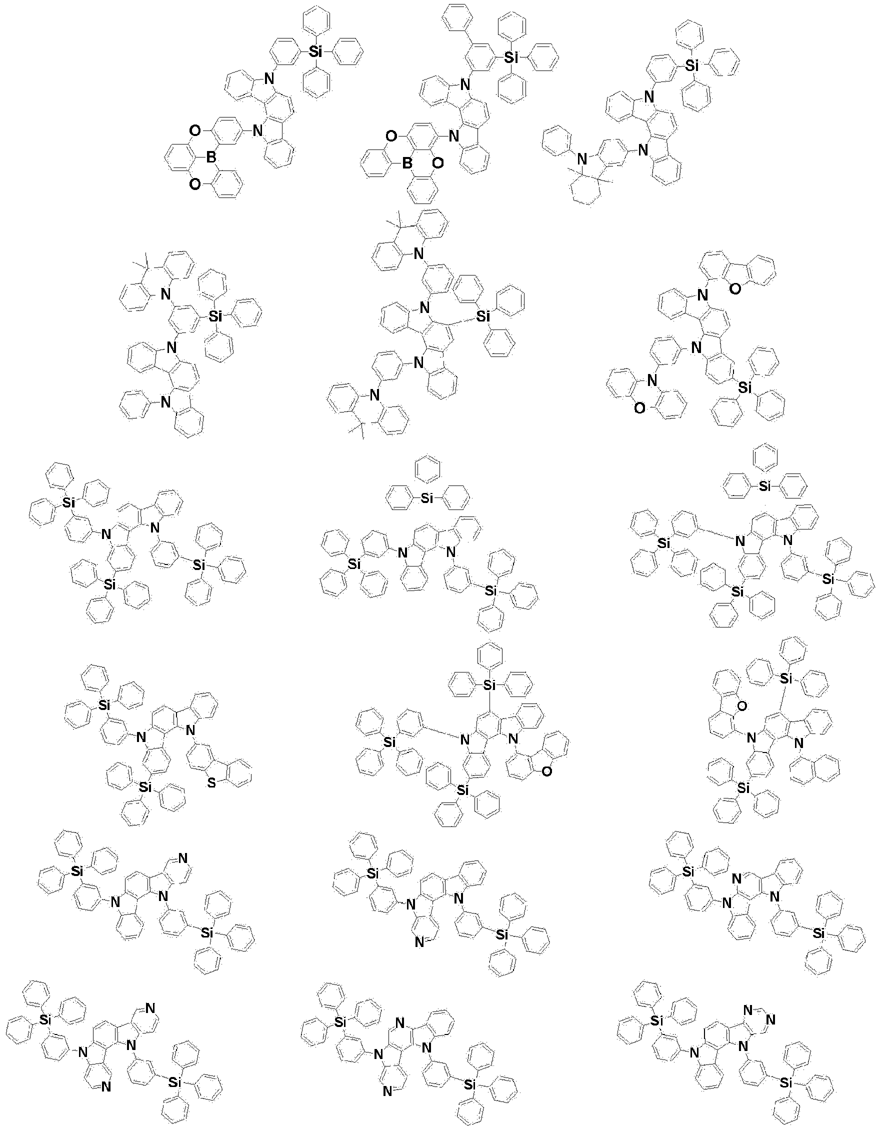

However, these compounds are not intended to limit the scope of Formula 1.

According to one embodiment of the present invention, the compounds represented by Formulas 2 and 3 may be selected from the following compounds:

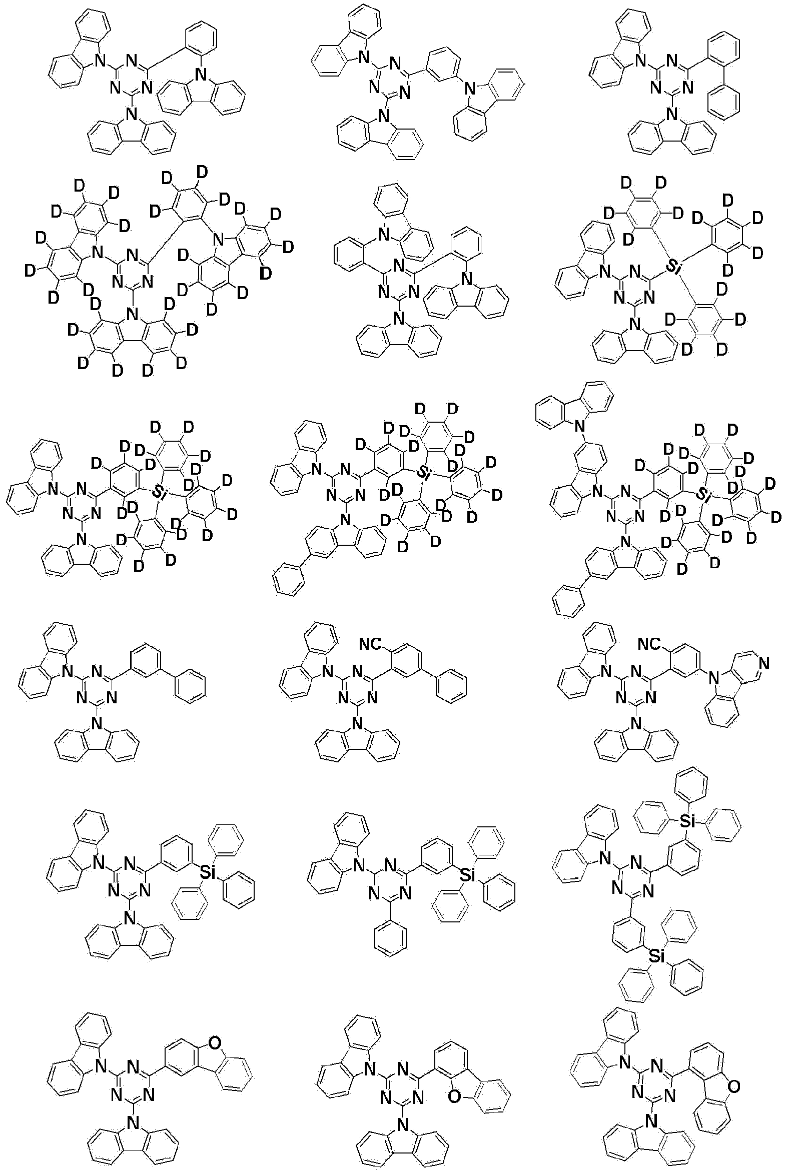

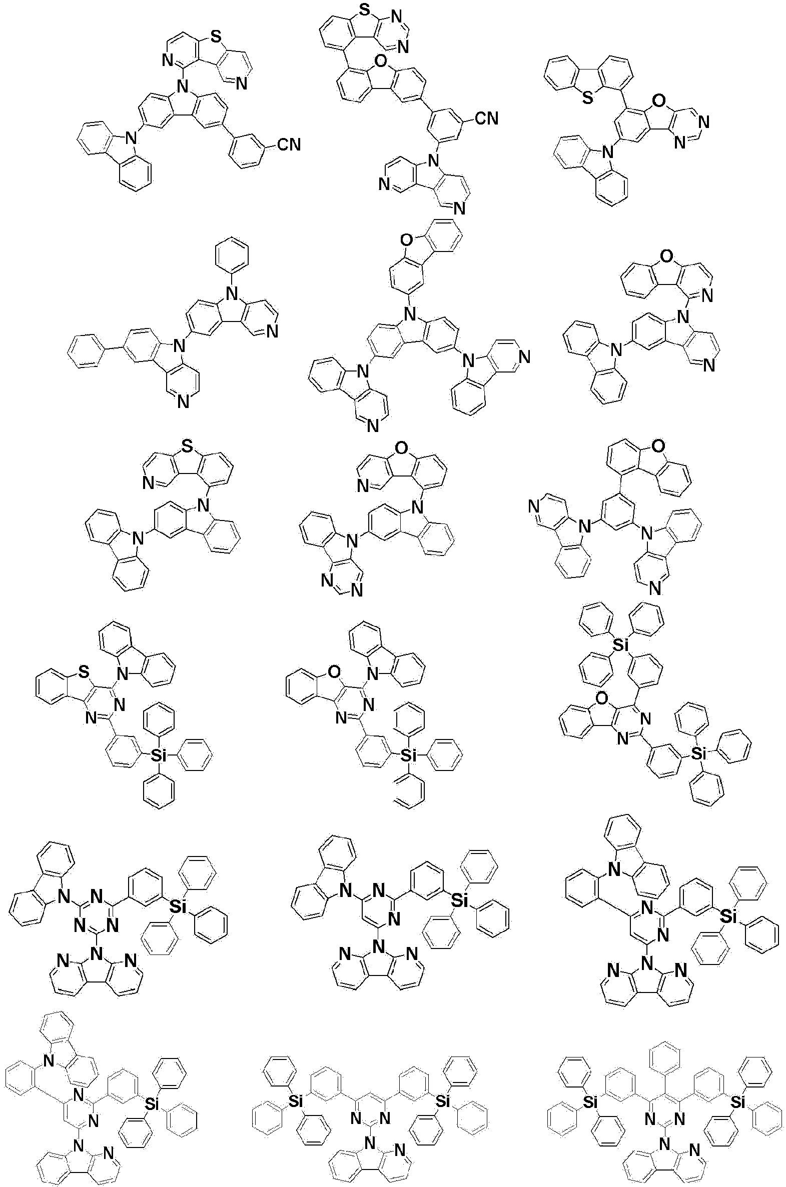

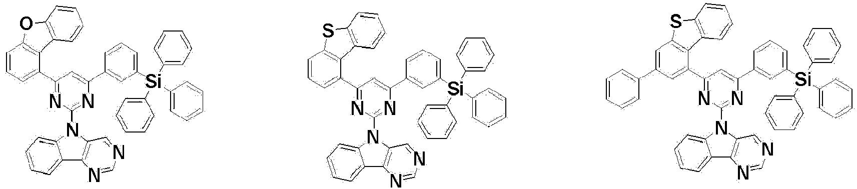

However, these compounds are not intended to limit the scopes of Formulas 2 and 3.

A more detailed description will be given concerning exemplary embodiments of the organic light emitting device according to the present invention.

The organic light emitting device of the present invention includes an anode, a hole transport layer, a light emitting layer, an electron transport layer, and a cathode. The organic light emitting device of the present invention may optionally further include a hole injecting layer between the anode and the hole transport layer and an electron injecting layer between the electron transport layer and the cathode. If necessary, the organic light emitting device of the present invention may further include one or two intermediate layers such as a hole blocking layer or an electron blocking layer. The organic light emitting device of the present invention may further include one or more organic layers such as a capping layer that have various functions depending on the desired characteristics of the device.

A specific structure of the organic light emitting device according to one embodiment of the present invention, a method for fabricating the device, and materials for the organic layers are as follows.

First, an anode material is coated on a substrate to form an anode. The substrate may be any of those used in general organic light emitting devices. The substrate is preferably an organic substrate or a transparent plastic substrate that is excellent in transparency, surface smoothness, ease of handling, and waterproofness. A highly transparent and conductive metal oxide such as indium tin oxide (ITO), indium zinc oxide (IZO), tin oxide (SnO₂) or zinc oxide (ZnO) is used as the anode material.

A hole injecting material is coated on the anode by vacuum thermal evaporation or spin coating to form a hole injecting layer. Then, a hole transport material is coated on the hole injecting layer by vacuum thermal evaporation or spin coating to form a hole transport layer.

The hole injecting material is not specially limited so long as it is usually used in the art. Specific examples of such materials include 1,4,5,8,9,11-hexaazatriphenylenehexacarbonitrile (HAT-CN), 4,4',4"-tris(2-naphthylphenyl-phenylamino)triphenylamine (2-TNATA), N,N'-di(1-naphthyl)-N,N'-diphenylbenzidine (NPD), N,N'-diphenyl-N,N'-bis(3-methylphenyl)-1,1'-biphenyl-4,4'-diamine (TPD), and N,N'-diphenyl-N,N'-bis(4-(phenyl-m-tolylamino)phenyl)biphenyl-4,4'-diamine (DNTPD).

The hole transport material is not specially limited so long as it is commonly used in the art. Examples of such materials include N,N'-bis(3-methylphenyl)-N,N'-diphenyl-(1,1-biphenyl)-4,4'-diamine (TPD) and N,N'-di(naphthalen-1-yl)-N,N'-diphenylbenzidine (α-NPD).

Subsequently, a hole auxiliary layer and a light emitting layer are sequentially stacked on the hole transport layer. A hole blocking layer may be optionally formed on the light emitting layer by vacuum thermal evaporation or spin coating. The hole blocking layer is formed as a thin film and blocks holes from entering a cathode through the organic light emitting layer. This role of the hole blocking layer prevents the lifetime and efficiency of the device from deteriorating. A material having a very low highest occupied molecular orbital (HOMO) energy level is used for the hole blocking layer. The hole blocking material is not particularly limited so long as it can transport electrons and has a higher ionization potential than the light emitting compound. Representative examples of suitable hole blocking materials include BAlq, BCP, and TPBI.

Examples of materials for the hole blocking layer include, but are not limited to, BAlq, BCP, Bphen, TPBI, TAZ, BeBq₂, OXD-7, and Liq.

An electron transport layer is deposited on the hole blocking layer by vacuum thermal evaporation or spin coating, and an electron injecting layer is formed thereon. A cathode metal is deposited on the electron injecting layer by vacuum thermal evaporation to form a cathode, completing the fabrication of the organic light emitting device.

For example, lithium (Li), magnesium (Mg), aluminum (Al), aluminum-lithium (Al-Li), calcium (Ca), magnesium-indium (Mg-In) or magnesium-silver (Mg-Ag) may be used as the metal for the formation of the cathode. The organic light emitting device may be of top emission type. In this case, a transmissive material such as ITO or IZO may be used to form the cathode.

A material for the electron transport layer functions to stably transport electrons injected from the cathode. The electron transport material may be any of those known in the art and examples thereof include, but are not limited to, quinoline derivatives, particularly tris(8-quinolinolato)aluminum (Alq₃), TAZ, BAlq, beryllium bis(benzoquinolin-10-olate) (Bebq₂), and oxadiazole derivatives such as PBD, BMD, and BND.

The organic light emitting device of the present invention may further include a light emitting layer composed of a material that emits blue, green or red light in the wavelength range of 380 nm to 800 nm. That is, the organic light emitting device of the present invention may include a plurality of light emitting layers. The blue, green or red light emitting material for the additional light emitting layer may be a fluorescent or phosphorescent material.

Each of the organic layers can be formed by a monomolecular deposition or solution process. According to the monomolecular deposition process, the material for each layer is evaporated into a thin film under heat and vacuum or reduced pressure. According to the solution process, the material for each layer is mixed with a suitable solvent and the mixture is then formed into a thin film by a suitable method such as inkjet printing, roll-to-roll coating, screen printing, spray coating, dip coating or spin coating.

The organic light emitting device of the present invention can be used in a display or lighting system selected from flat panel displays, flexible displays, monochromatic flat panel lighting systems, white flat panel lighting systems, flexible monochromatic lighting systems, flexible white lighting systems, displays for automotive applications, displays for virtual reality, and displays for augmented reality.

The present invention will be more specifically explained with reference to the following synthesis examples and fabrication examples. However, these examples are provided to assist in understanding the invention and are not intended to limit the scope of the present invention.

### Synthesis Example 1. Synthesis of HT-1

### Synthesis Example 1-1: Synthesis of HT-1

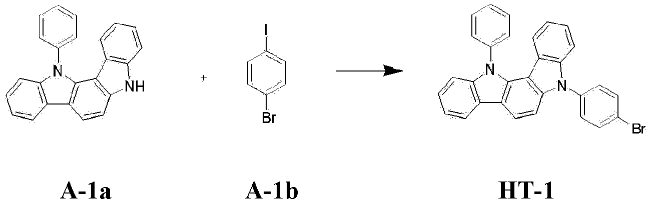

15 g of **A-1a,** 24.4 g of **A-1b,** 0.8 g of Pd₂(dba)₃, 6.5 g of STB, and 150 mL of toluene were heated with stirring in a round bottom flask under a nitrogen atmosphere. When the temperature reached 40 °C, 0.4 g of P(t-Bu)₃ was added, followed by reflux. After completion of the reaction, the reaction mixture was allowed to stand for layer separation. The organic layer was concentrated under reduced pressure and purified by column chromatography to afford **HT-1** (10 g, 34%).
MS (MALDI-TOF): m/z 666.25 [M⁺]

### Synthesis Example 2: Synthesis of HT-2

### Synthesis Example 2-1: Synthesis of B-1

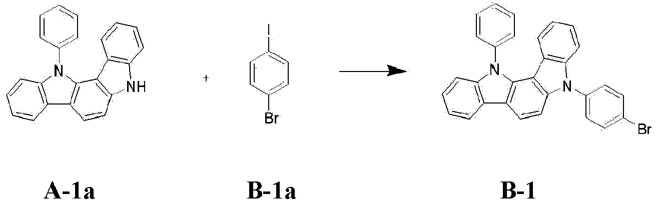

30 g of **A-1a,** 32.2 g of **B-1a,** 0.8 g of CuI, 38.4 g of K₃CO₄, 20.6 g of 1,2-cyclohexyldiamine, and 240 mL of 1,4-dioxane were refluxed with stirring in a round bottom flask under a nitrogen atmosphere. After completion of the reaction, the reaction mixture was allowed to stand for layer separation. The organic layer was concentrated under reduced pressure and purified by column chromatography to afford **B-1** (33 g, 75%).

### Synthesis Example 2-2: Synthesis of HT-2

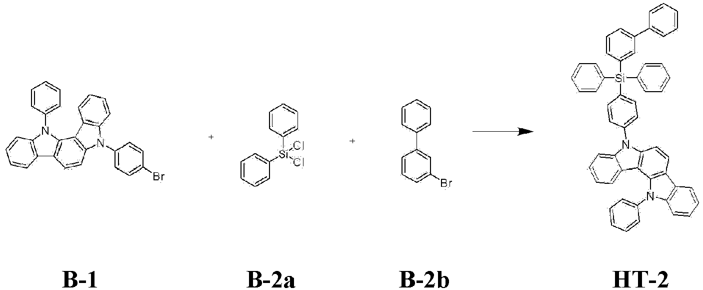

32.7 g of **B-1,** 17 g of **B-2a,** and 100 mL of THF were placed in a round bottom flask. The mixture was cooled to -78 °C under a nitrogen atmosphere, followed by stirring. After slow dropwise addition of 42 mL of n-BuLi, stirring was continued at low temperature for 30 min. To the reaction mixture was added dropwise a solution of**B-2b** in 200 mL of THF. The resulting mixture was added dropwise with 42 mL of n-BuLi and the temperature was raised to room temperature with stirring. After completion of the reaction, the reaction mixture was allowed to stand for layer separation. The organic layer was concentrated under reduced pressure and purified by column chromatography to afford **HT-2** (21 g, 43%).
MS (MALDI-TOF): m/z 742.28 [M⁺]

### Synthesis Example 3: Synthesis of HT-3

### Synthesis Example 3-1: Synthesis of C-1

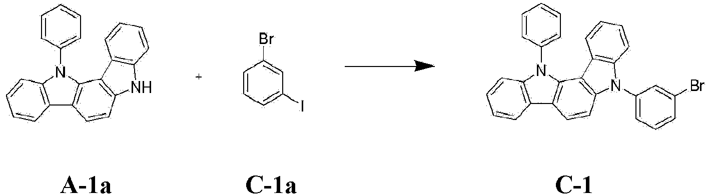

**C-1** (yield 62%) was synthesized in the same manner as in Synthesis Example 2-1, except that **C-1a** was used instead of**B-1a.**

### Synthesis Example 3-2: Synthesis of HT-3

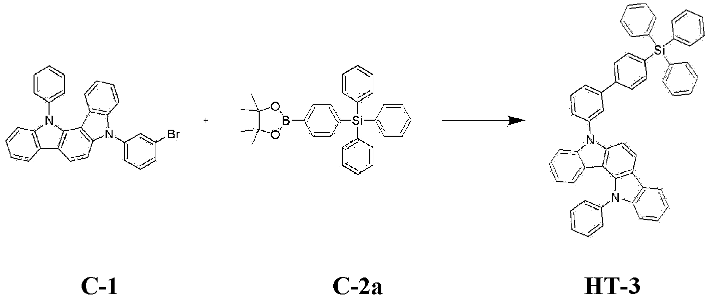

23.2 g of **C-1**, 26.8 g of **C-2a,** 1.2 g of Pd(pph₃)₄, 11.6 g of K₂CO₃, 160 mL of toluene, 40 mL of ethanol, and 40 mL of water were placed in a round bottom flask. The mixture was stirred under reflex. After completion of the reaction, the reaction mixture was allowed to stand for layer separation. The organic layer was concentrated under reduced pressure and purified by column chromatography to afford **HT-3** (20 g, 52%).
MS (MALDI-TOF): m/z 742.28 [M⁺]

### Synthesis Example 4: Synthesis of HT-4

### Synthesis Example 4-1: Synthesis of HT-4

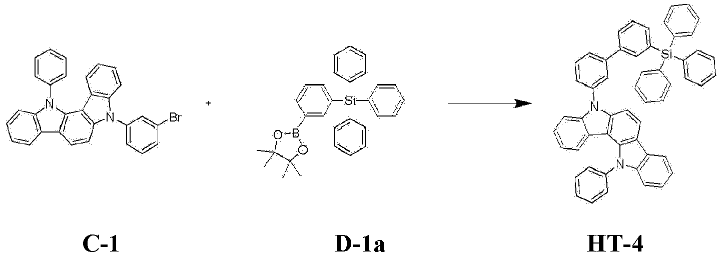

**HT-4** (yield 62%) was synthesized in the same manner as in Synthesis Example 3-2, except that **D-la** was used instead of**C-2a**.
MS (MALDI-TOF): m/z 742.28 [M⁺]

### Synthesis Example 5: Synthesis of HT-5

### Synthesis Example 5-1: Synthesis of E-1

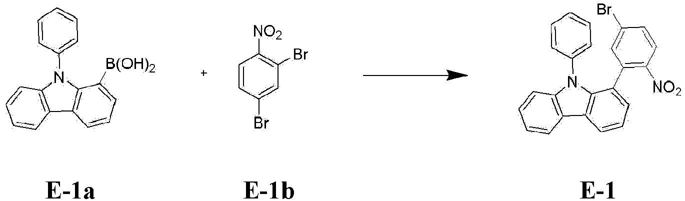

**E-1** (yield 60%) was synthesized in the same manner as in Synthesis Example 3-2, except that **E-1a** and **E-1b** were used instead of **C-2a** and **C-1,** respectively.

### Synthesis Example 5-2: Synthesis of E-2

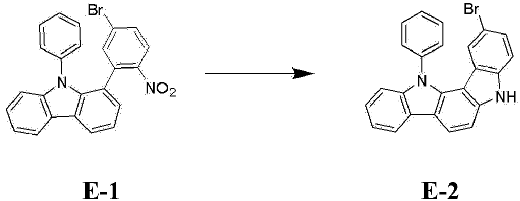

50 g of **E-1**, 105 g of triphenylphosphine, and 500 mL of dichlorobenzene were refluxed in a round bottom flask under a nitrogen atmosphere. After completion of the reaction, the reaction mixture was allowed to stand for layer separation. The organic layer was concentrated under reduced pressure and purified by column chromatography to afford **E-2** (30 g, 65%).

### Synthesis Example 5-3: Synthesis of E-3

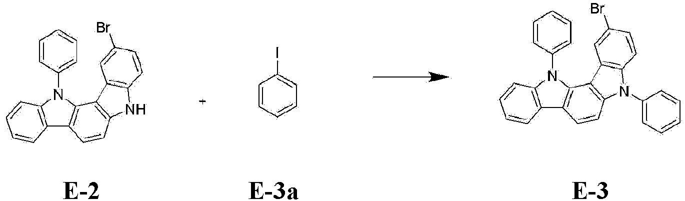

**E-3** (yield 62%) was synthesized in the same manner as in Synthesis Example 2-1, except that **E-2** and **E-3a** were used instead of **A-1a** and **B-1a,** respectively.

### Synthesis Example 5-4: Synthesis of HT-5

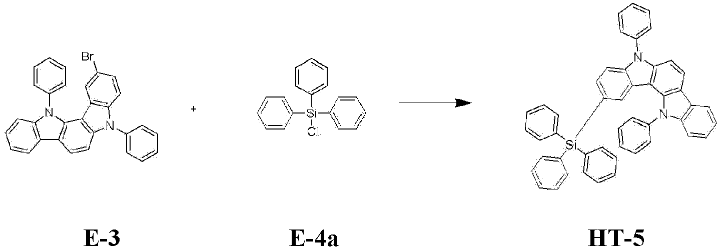

28.1 g of **E-3** and 100 mL of THF were placed in a round bottom flask. The mixture was cooled to -78 °C under a nitrogen atmosphere, followed by stirring. After slow dropwise addition of 42 mL of n-BuLi, stirring was continued at low temperature for 30 min. The reaction mixture was added dropwise with 17 g of **E-4a** and the temperature was raised to room temperature with stirring. After completion of the reaction, the reaction mixture was allowed to stand for layer separation. The organic layer was concentrated under reduced pressure and purified by column chromatography to afford **HT-5** (19 g, 51%).
MS (MALDI-TOF): m/z 666.25 [M⁺]

### Synthesis Example 6: Synthesis of HT-6

### Synthesis Example 6-1: Synthesis of HT-6

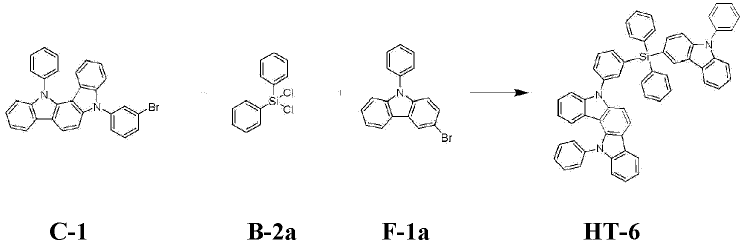

**HT-6** (yield 53%) was synthesized in the same manner as in Synthesis Example 2-2, except that **C-1** and **F-1a** were used instead **of B-1** and **B-2b,** respectively.
MS (MALDI-TOF): m/z 831.31 [M⁺]

### Synthesis Example 7: Synthesis of HT-7

### Synthesis Example 7-1: Synthesis of G-1

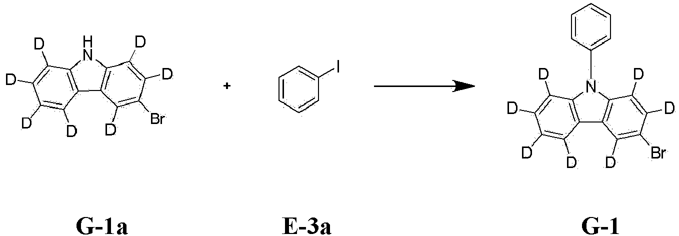

**G-1** (yield 61%) was synthesized in the same manner as in Synthesis Example 2-1, except that **G-1a** and **E-3a** were used instead of **A-1a** and **B-1a,** respectively.

### Synthesis Example 7-2: Synthesis of G-2

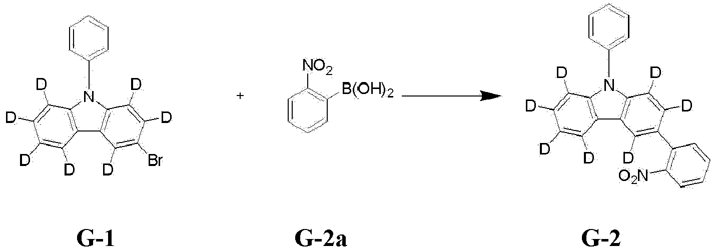

**G-2** (yield 66%) was synthesized in the same manner as in Synthesis Example 3-2, except that **G-1** and **G-2a** were used instead of **C-1** and **C-2a,** respectively.

### Synthesis Example 7-3: Synthesis of G-3

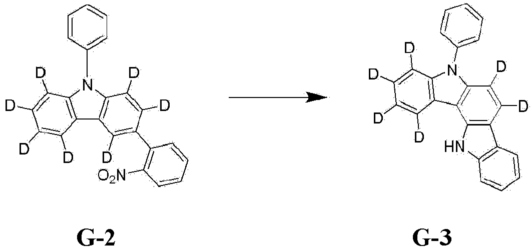

**G-3** (yield 69%) was synthesized in the same manner as in Synthesis Example 5-2, except that **G-2** was used instead of**E-1.**

### Synthesis Example 7-4: Synthesis of HT-7

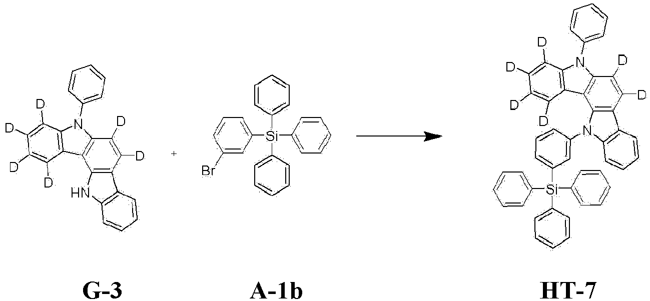

**HT-7** (yield 62%) was synthesized in the same manner as in Synthesis Example 1-1, except that **G-3** was used instead of**A-1a.**
MS (MALDI-TOF): m/z 672.29 [M⁺]

### Synthesis Example 8: Synthesis of HT-8

### Synthesis Example 8-1: Synthesis of HT-8

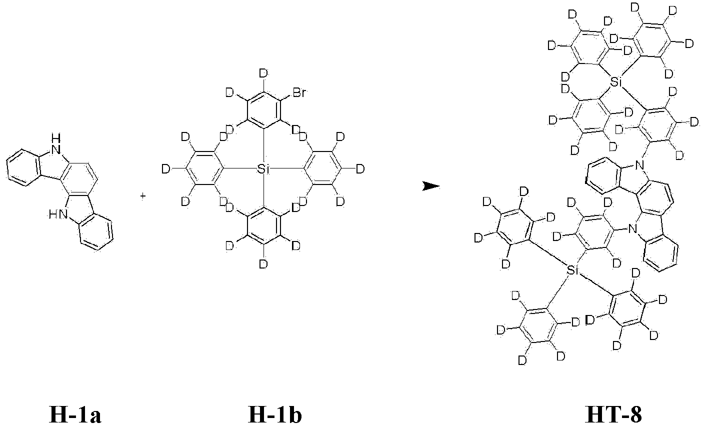

**HT-8** (yield 67%) was synthesized in the same manner as in Synthesis Example 1-1, except that **H-1a** and two equivalents of **H-1b** were used instead of **A-1a** and **A-1b,** respectively.
MS (MALDI-TOF): m/z 962.57 [M⁺]

### Synthesis Example 9: Synthesis of HT-9

### Synthesis Example 9-1: Synthesis of I-1

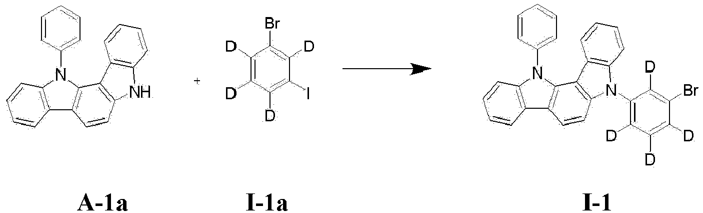

**I-1** (yield 56%) was synthesized in the same manner as in Synthesis Example 2-1, except that **I-1a** was used instead of**B-1a.**

### Synthesis Example 9-2: Synthesis of HT-9

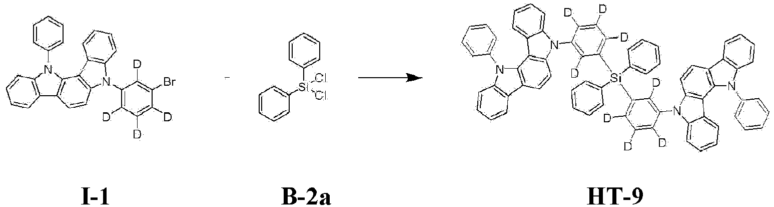

34 g of **I-1,** 8 g of **B-2a,** and 300 mL of THF were placed in a round bottom flask. The mixture was cooled to -78°C under a nitrogen atmosphere, followed by stirring. After slow dropwise addition of 52 mL of n-BuLi, stirring was continued at low temperature for 30 min. Thereafter, the temperature was raised to room temperature with stirring. After completion of the reaction, the reaction mixture was allowed to stand for layer separation. The organic layer was concentrated under reduced pressure and purified by column chromatography to afford **HT-9** (18 g, 57%).
MS (MALDI-TOF): m/z 1004.42 [M⁺]

### Synthesis Example 10: Synthesis of HT-10

### Synthesis Example 10-1: Synthesis of J-1

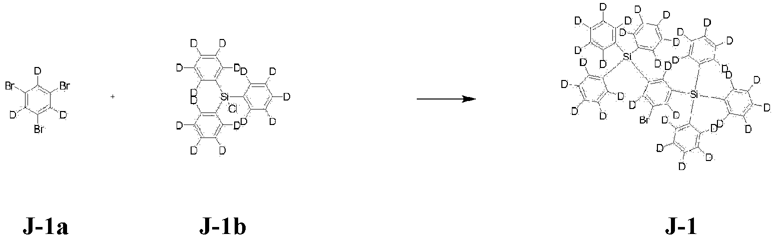

20 g of **J-1a** was added to 200 mL of THF in a round bottom flask. The mixture was cooled to -78 °C under a nitrogen atmosphere, followed by stirring. After slow dropwise addition of 58 mL of n-BuLi, stirring was continued at low temperature for 30 min. Thereafter, the resulting mixture was allowed to react with 41 g of **J-1b** and 400 mL of THF. The temperature was raised to room temperature with stirring. After completion of the reaction, the reaction mixture was allowed to stand for layer separation. The organic layer was concentrated under reduced pressure and purified by column chromatography to afford **J-1** (18 g, 45%).

### Synthesis Example 10-2: Synthesis of HT-10

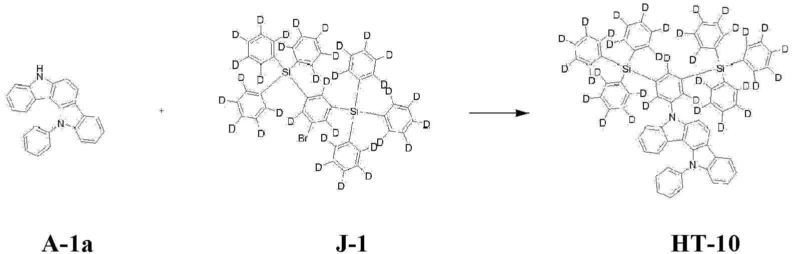

**HT-10** (yield 47%) was synthesized in the same manner as in Synthesis Example 1-1, except that **J-1** was used instead **of A-1b.**
MS (MALDI-TOF): m/z 957.54 [M⁺]

### Synthesis Example 11: Synthesis of HT-11

### Synthesis Example 11-1: Synthesis of K-1

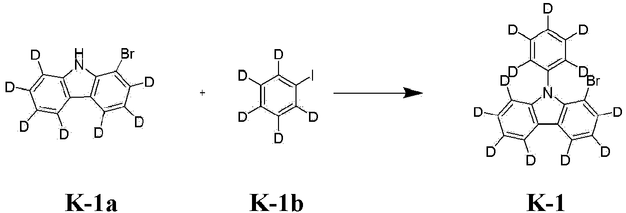

**K-1** (yield 59%) was synthesized in the same manner as in Synthesis Example 2-1, except that **K-1a** and **K-1b** were used instead of **A-1a** and **B-1a,** respectively.

### Synthesis Example 11-2: Synthesis of K-2

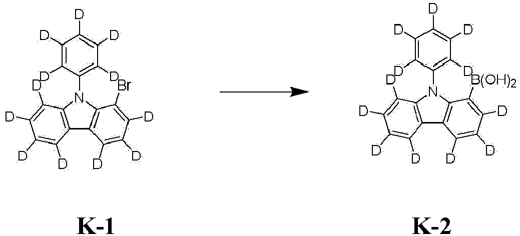

20 g of **K-1** was added to 160 mL of THF in a round bottom flask. The mixture was cooled to -78 °C under a nitrogen atmosphere, followed by stirring. After slow dropwise addition of 37 mL of n-BuLi, stirring was continued at low temperature for 30 min. After 1 h, the resulting mixture was added with 10 mL of trimethyl borate and the temperature was raised to room temperature with stirring. After completion of the reaction, the reaction mixture was allowed to stand for layer separation. The organic layer was concentrated under reduced pressure and purified by column chromatography to afford **K-2** (13 g, 73%).

### Synthesis Example 11-3: Synthesis of K-3

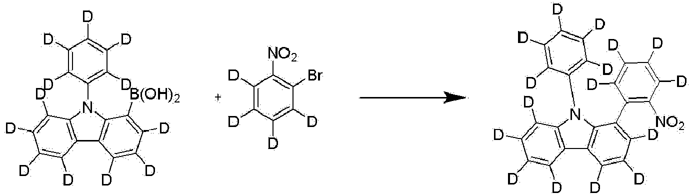

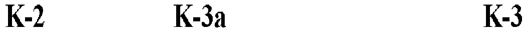

**K-3** (yield 69%) was synthesized in the same manner as in Synthesis Example 3-2, except that **K-3a** and **K-2** were used instead of **C-1** and **C-2a,** respectively.

### Synthesis Example 11-4: Synthesis of K-4

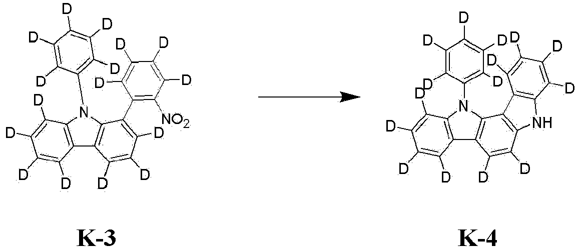

**K-4** (yield 64%) was synthesized in the same manner as in Synthesis Example 5-2, except that **K-3** was used instead of**E-1.**

### Synthesis Example 11-5: Synthesis of HT-11

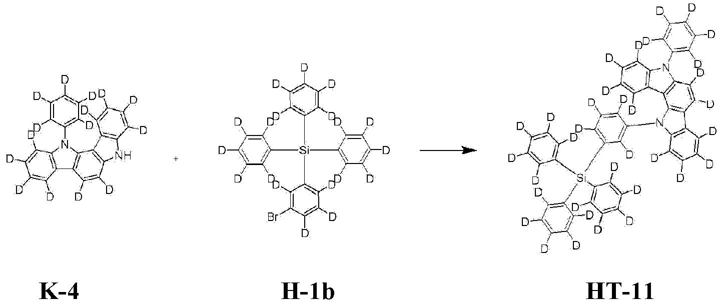

**HT-11** (yield 49%) was synthesized in the same manner as in Synthesis Example 1-1, except that **K-4** and **H-1b** were used instead of **A-1a** and **A-1b,** respectively.
MS (MALDI-TOF): m/z 700.46 [M⁺]

### Synthesis Example 12: Synthesis of HT-12

### Synthesis Example 12-1: Synthesis of L-1

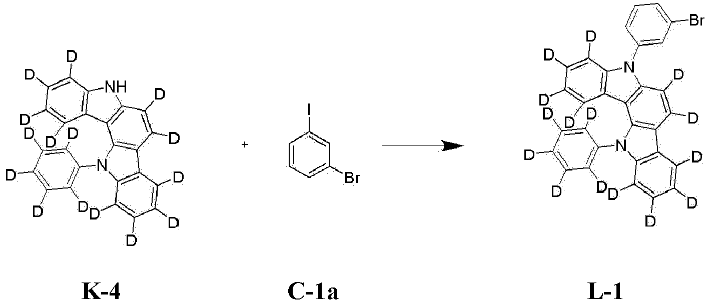

**L-1** (yield 61%) was synthesized in the same manner as in Synthesis Example 2-1, except that **K-4** and **C-1a** were used instead of **A-1a** and **B-1a,** respectively.

### Synthesis Example 12-2: Synthesis of HT-12

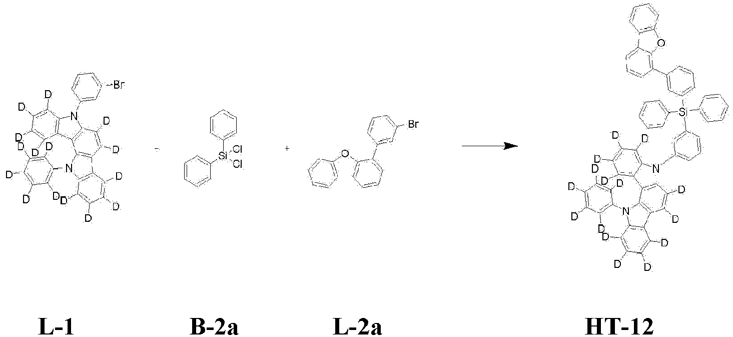

**HT-12** (yield 41%) was synthesized in the same manner as in Synthesis Example 2-2, except that **L-1** and **B-2a** were used instead of **B-1** and **B-2b,** respectively.
MS (MALDI-TOF): m/z 847.39 [M⁺]

### Synthesis Example 13: Synthesis of HT-13

### Synthesis Example 13-1: Synthesis of HT-13

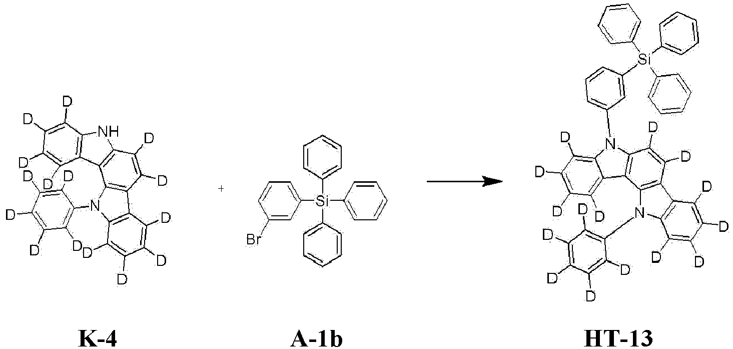

**HT-13** (yield 49%) was synthesized in the same manner as in Synthesis Example 2-1, except that **K-4** and **A-1b** were used instead of **A-1a** and **B-1a,** respectively.
MS (MALDI-TOF): m/z 681.34 [M⁺]

### Synthesis Example 14: Synthesis of ET-1

### Synthesis Example 14-1: Synthesis of M-1

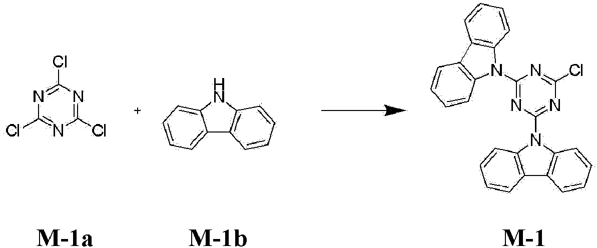

30 g of **M-1b** and 450 mL of tetrahydrofuran were stirred in a round bottom flask at 0 °C and 70 mL of 2.5 M n-BuLi was slowly added dropwise thereto. Stirring was continued for 30 min. Thereafter, a solution of 15 g of **M-1a** in THF was added dropwise to the reactor, followed by stirring under reflux. After completion of the reaction, the reaction mixture was allowed to stand for layer separation. The organic layer was concentrated under reduced pressure and recrystallized from tetrahydrofuran and methanol to afford **M-1** (21.7 g, 55%).

### Synthesis Example 14-2: Synthesis of ET-1

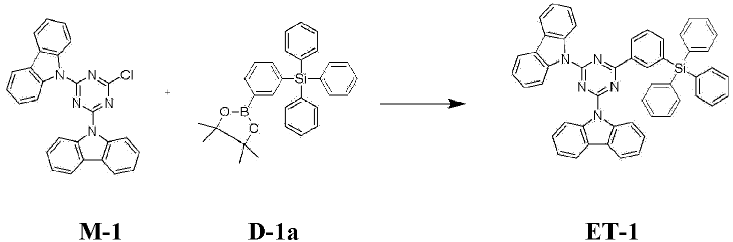

**ET-1** (yield 55%) was synthesized in the same manner as in Synthesis Example 3-2, except that **M-1** and **D-la** were used instead of **C-1** and **C-2a,** respectively.
MS (MALDI-TOF): m/z 745.27 [M⁺]

### Synthesis Example 15: Synthesis of ET-2

### Synthesis Example 15-2: Synthesis of ET-2

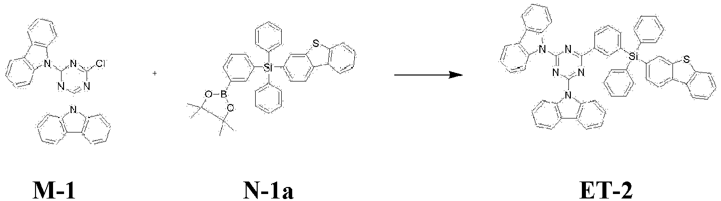

**ET-2** (yield 51%) was synthesized in the same manner as in Synthesis Example 3-2, except that **M-1** and **N-1a** were used instead of **C-1** and **C-2a,** respectively.
MS (MALDI-TOF): m/z 851.25 [M⁺]

### Synthesis Example 16: Synthesis of ET-3

### Synthesis Example 16-1: Synthesis of ET-3

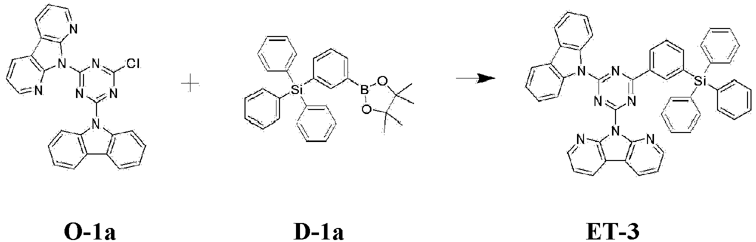

**ET-3** (yield 55%) was synthesized in the same manner as in Synthesis Example 3-2, except that **N-1** and **D-la** were used instead of **C-1** and **C-2a,** respectively.
MS (MALDI-TOF): m/z 747.26 [M⁺]

### Synthesis Example 17: Synthesis of ET-4

### Synthesis Example 17-1: Synthesis of ET-4

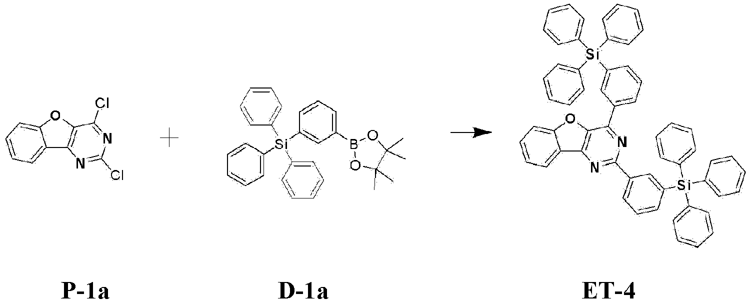

**ET-4** (yield 54%) was synthesized in the same manner as in Synthesis Example 3-2, except that **O-1** and **D-la** were used instead of **C-1** and **C-2a,** respectively.
MS (MALDI-TOF): m/z 838.28 [M⁺]

### Examples 1-13: Fabrication of organic light emitting devices

ITO glass was patterned to have a light emitting area of 2 mm × 2 mm, followed by cleaning. After the cleaned ITO glass was mounted in a vacuum chamber, the base pressure was adjusted to 1 × 10⁻⁶ torr. HAT-CN and BCFN were used to sequentially form a 50 Å thick hole injecting layer and a 600 Å hole transport layer on the ITO glass, respectively. PBCz was used to form a 50 Å electron blocking layer. A mixture of the compound shown in Table 1 as a host compound and 12 wt% of PBD as a dopant compound was used to form a 350 Å thick light emitting layer. Then, mSiTrz, a mixture of mSiTrz and Liq in a ratio of 1:1, Liq, and Al were used to sequentially form a 50 Å thick hole blocking layer, a 300 Å thick electron transport/injecting layer, a 10 Å thick electron injecting layer, and a 1,000 Å thick cathode on the light emitting layer, respectively, completing the fabrication of an organic light emitting device. The luminescent properties of the organic light emitting device were measured at 0.4 mA.

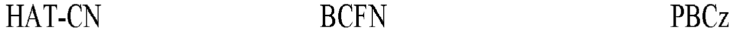

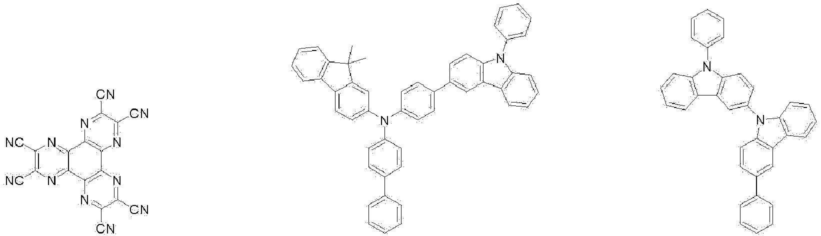

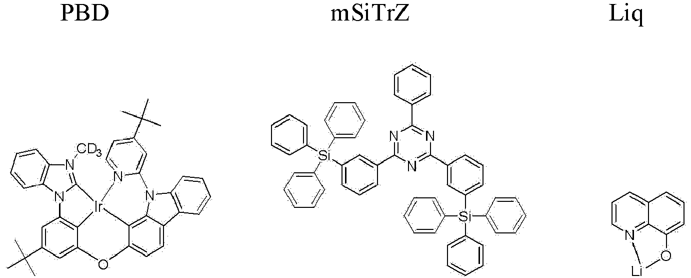

### Comparative Examples 1-3

Organic light emitting devices were fabricated in the same manner as in Examples 1-13, except that one **of RH-1** to **RH-3** was used as a host compound instead of the inventive compound. The luminescent properties of the organic light emitting devices were measured at 0.4 mA. The structures of **RH-1, RH-2,** and **RH-3** are as follow:

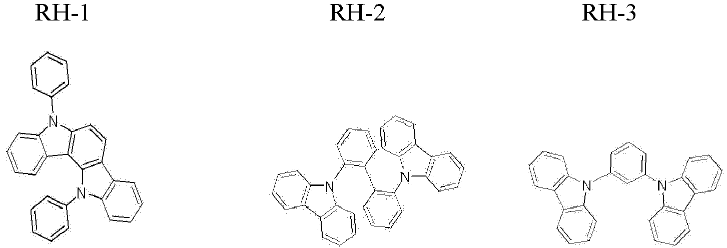

**Table 1**

| Example No. | Host | Driving voltage (V) | External quantum efficiency (%) | Color of light emission | Lifetime (T80, hr) |
|---|---|---|---|---|---|
| Example 1 | HT-1 | 4.5 | 16.5 | Blue | 81 |
| Example 2 | HT-2 | 4.7 | 16.7 | Blue | 86 |
| Example 3 | HT-3 | 4.7 | 16.6 | Blue | 83 |
| Example 4 | HT-4 | 4.6 | 16.7 | Blue | 84 |
| Example 5 | HT-5 | 4.8 | 16.4 | Blue | 80 |
| Example 6 | HT-6 | 4.6 | 16.6 | Blue | 82 |
| Example 7 | HT-7 | 4.5 | 16.4 | Blue | 86 |
| Example 8 | HT-8 | 4.7 | 16.6 | Blue | 90 |
| Example 9 | HT-9 | 4.8 | 16.2 | Blue | 83 |
| Example 10 | HT-10 | 4.6 | 16.5 | Blue | 89 |
| Example 11 | HT-11 | 4.5 | 16.5 | Blue | 101 |
| Example 12 | HT-12 | 4.7 | 16.5 | Blue | 90 |
| Example 13 | HT-13 | 4.5 | 16.5 | Blue | 92 |
| Comparative Example 1 | RH-1 | 5.5 | 11.7 | Blue | 20 |
| Comparative Example 2 | RH-2 | 5.5 | 11.8 | Blue | 18 |
| Comparative Example 3 | RH-3 | 5.6 | 10.4 | Blue | 14 |

As can be seen from the results in Table 1, the organic light emitting devices of Examples 1-13, each of which employed the inventive host compound for the light emitting layer, had high quantum efficiencies and improved life characteristics at low driving voltages compared to the organic light emitting devices of Comparative Examples 1-3, each of which employed the compound that is widely used in the art and whose specific structure is contrasted with those of the inventive compounds. These results concluded that the use of the inventive compounds makes the organic light emitting devices highly efficient and long lasting.

### Examples 14-37: Fabrication of organic light emitting devices

Organic light emitting devices were fabricated in the same manner as in Examples 1-13, except that a mixture of the inventive host compound shown in Table 2 and one of **ET-1** to **ET-4** in a weight ratio of 1:1 was used to form the light emitting layer instead of the inventive host compound shown in Table 1. The luminescent properties of the organic light emitting devices were measured at 0.4 mA.

### Comparative Examples 4-15

Organic light emitting devices were fabricated in the same manner as in Examples 14-37, except that one of **RH-1** to **RH-3** was used to form the light emitting layer instead of the inventive host compound shown in Table 2. The luminescent properties of the organic light emitting devices were measured at 0.4 mA.

**Table 2**

| Example No. | First host | Second host | Driving voltage (V) | External quantum efficiency (%) | Color of light emission | Lifetime (T80, hr) |
|---|---|---|---|---|---|---|
| Example 14 | HT-1 | ET-1 | 4.4 | 17.7 | Blue | 116 |
| Example 15 | HT-2 | ET-1 | 4.5 | 18.0 | Blue | 127 |
| Example 16 | HT-5 | ET-1 | 4.6 | 17.3 | Blue | 111 |
| Example 17 | HT-7 | ET-1 | 4.4 | 17.6 | Blue | 186 |
| Example 18 | HT-11 | ET-1 | 4.5 | 17.7 | Blue | 202 |
| Example 19 | HT-13 | ET-1 | 4.5 | 17.7 | Blue | 114 |
| Example 20 | HT-1 | ET-2 | 4.5 | 17.7 | Blue | 118 |
| Example 21 | HT-2 | ET-2 | 4.6 | 18.1 | Blue | 127 |
| Example 22 | HT-5 | ET-2 | 4.6 | 17.4 | Blue | 112 |
| Example 23 | HT-7 | ET-2 | 4.5 | 17.6 | Blue | 188 |
| Example 24 | HT-11 | ET-2 | 4.6 | 17.7 | Blue | 205 |
| Example 25 | HT-13 | ET-2 | 4.5 | 17.7 | Blue | 116 |
| Example 26 | HT-1 | ET-3 | 4.7 | 17.5 | Blue | 113 |
| Example 27 | HT-2 | ET-3 | 4.7 | 17.8 | Blue | 123 |
| Example 28 | HT-5 | ET-3 | 4.8 | 17.3 | Blue | 111 |
| Example 29 | HT-7 | ET-3 | 4.6 | 17.4 | Blue | 182 |
| Example 30 | HT-11 | ET-3 | 4.7 | 17.5 | Blue | 197 |
| Example 31 | HT-13 | ET-3 | 4.6 | 17.4 | Blue | 110 |
| Example 32 | HT-1 | ET-4 | 4.4 | 17.6 | Blue | 118 |
| Example 33 | HT-2 | ET-4 | 4.4 | 17.9 | Blue | 130 |
| Example 34 | HT-5 | ET-4 | 4.5 | 17.2 | Blue | 115 |
| Example 35 | HT-7 | ET-4 | 4.3 | 17.5 | Blue | 188 |
| Example 36 | HT-11 | ET-4 | 4.3 | 17.6 | Blue | 206 |
| Example 37 | HT-13 | ET-4 | 4.3 | 17.6 | Blue | 117 |
| Comparative Example 4 | RH-1 | ET-1 | 5.4 | 13.5 | Blue | 25 |
| Comparative Example 5 | RH-2 | ET-1 | 5.3 | 13.5 | Blue | 23 |
| Comparative Example 6 | RH-3 | ET-1 | 5.4 | 12.1 | Blue | 24 |
| Comparative Example 7 | RH-1 | ET-2 | 5.3 | 13.3 | Blue | 26 |
| Comparative Example 8 | RH-2 | ET-2 | 5.5 | 13.5 | Blue | 23 |
| Comparative Example 9 | RH-3 | ET-2 | 5.6 | 12.1 | Blue | 23 |
| Comparative Example 10 | RH-1 | ET-3 | 5.6 | 12.4 | Blue | 24 |
| Comparative Example 11 | RH-2 | ET-3 | 5.3 | 13.6 | Blue | 22 |
| Comparative Example 12 | RH-3 | ET-3 | 5.4 | 12.3 | Blue | 23 |
| Comparative Example 13 | RH-1 | ET-4 | 5.5 | 13.1 | Blue | 25 |
| Comparative Example 14 | RH-2 | ET-4 | 5.1 | 13.3 | Blue | 29 |
| Comparative Example 15 | RH-3 | ET-4 | 5.2 | 12.0 | Blue | 30 |

As can be seen from the results in Table 2, the organic light emitting devices of Examples 14-37, each of which employed the inventive host compound for the light emitting layer, had high quantum efficiencies and improved life characteristics at low driving voltages compared to the organic light emitting devices of Comparative Examples 4-15, each of which employed the compound that is widely used in the art and whose specific structure is contrasted with those of the inventive compounds. These results concluded that the use of the inventive compounds makes the organic light emitting devices highly efficient and long lasting.

## Claims

1. An organic compound represented by Formula 1: 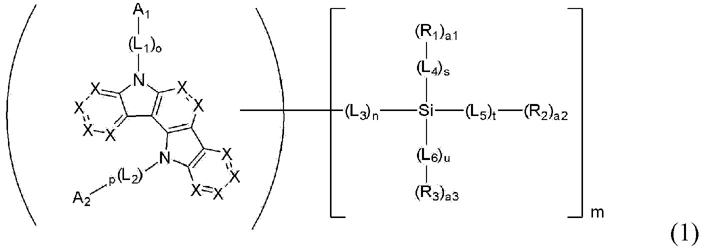 wherein the moieties X are the same as or different from each other and are each independently N or CR, the groups R are the same as or different from each other and are each independently selected from hydrogen, deuterium, substituted or unsubstituted C₁-C₃₀ alkyl, substituted or unsubstituted C₆-C₅₀ aryl, substituted or unsubstituted C₂-C₅₀ heteroaryl, and cyclic groups in which a substituted or unsubstituted C₃-C₃₀ aliphatic ring and a C₅-C₃₀ aromatic ring are fused together, A₁ and A₂ are the same as or different from each other and are each independently selected from substituted or unsubstituted C₆-C₅₀ aryl, substituted or unsubstituted C₂-C₅₀ heteroaryl, and cyclic groups in which a substituted or unsubstituted C₃-C₃₀ aliphatic ring and a C₅-C₃₀ aromatic ring are fused together, R₁ to R₃ are the same as or different from each other and are each independently selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₅₀ cycloalkyl, substituted or unsubstituted C₂-C₅₀ heterocycloalkyl, substituted or unsubstituted C₂-C₅₀ heteroaryl, and cyclic groups in which a substituted or unsubstituted C₃-C₃₀ aliphatic ring and a C₅-C₃₀ aromatic ring are fused together, L₁ to L₆ are the same as or different from each other and each independently represent a single bond or are each independently selected from substituted or unsubstituted C₆-C₃₀ arylene, substituted or unsubstituted C₂-C₃₀ heteroarylene, and divalent cyclic groups in which a substituted or unsubstituted C₃-C₂₄ aliphatic ring and a C₅-C₂₄ aromatic ring are fused together, a₁ to a₃ are integers from 1 to 3, provided that when a₁ to a₃ are integers greater than or equal to 2, the groups R₁ to R₃ are the same as or different from each other, respectively, each of n, o, p, s, t, and u is an integer of 1 or 2, provided that when n, o, p, s, t, and u are integers greater than or equal to 2, L₁ to L₆ are the same as or different from each other, respectively, m is an integer from 1 to 4, provided that when m is an integer greater than or equal to 2, the bracketed structures are the same as or different from each other, with the proviso that adjacent ones of the groups R are optionally linked to each other to form an alicyclic or aromatic monocyclic or polycyclic ring, the "substituted" in the definitions of X, A₁, A₂, R₁ to R₃, and L₁ to L₆ in Formula 1 indicating substitution with one or more substituents selected from deuterium, C₁-C₂₄ alkyl, C₁-C₂₄ haloalkyl, C₂-C₂₄ alkenyl, C₂-C₂₄ alkynyl, C₃-C₃₀ cycloalkyl, C₁-C₂₄ heteroalkyl, C₆-C₃₀ aryl, C₇-C₃₀ arylalkyl, C₇-C₃₀ alkylaryl, C₂-C₃₀ heteroaryl, C₂-C₃₀ heteroarylalkyl, C₃-C₃₀ alkylheteroaryl, cyclic groups in which a substituted or unsubstituted C₃-C₂₄ aliphatic ring and a C₅-C₂₄ aromatic ring are fused together, C₁-C₂₄ alkoxy, C₁-C₃₀ amine, C₁-C₃₀ silyl, C₁-C₃₀ germanium, C₆-C₂₄ aryloxy, C₆-C₂₄ arylthionyl, cyano, halogen, hydroxyl, and nitro, or a combination thereof, provided that when substituted with two or more substituents, the substituents are identical to or different from each other, the "unsubstituted" in the same definition indicating having no substituent, and one or more hydrogen atoms in each of the substituents being optionally replaced by deuterium atoms.

2. The organic compound according to claim 1, wherein A₁ and A₂ are the same as or different from each other and are each independently substituted or unsubstituted C₆-C₃₀ aryl.

3. The organic compound according to claim 2, wherein m is an integer of 1 and L₃ forms a single bond with at least one of A₁ and A₂.

4. The organic compound according to claim 1, wherein the organic compound is deuterated.

5. The organic compound according to claim 1, wherein R₁ to R₃ are the same as or different from each other and are each independently substituted or unsubstituted C₆-C₁₄ aryl.

6. The organic compound according to claim 1, wherein the organic compound represented by Formula 1 is selected from the following compounds:

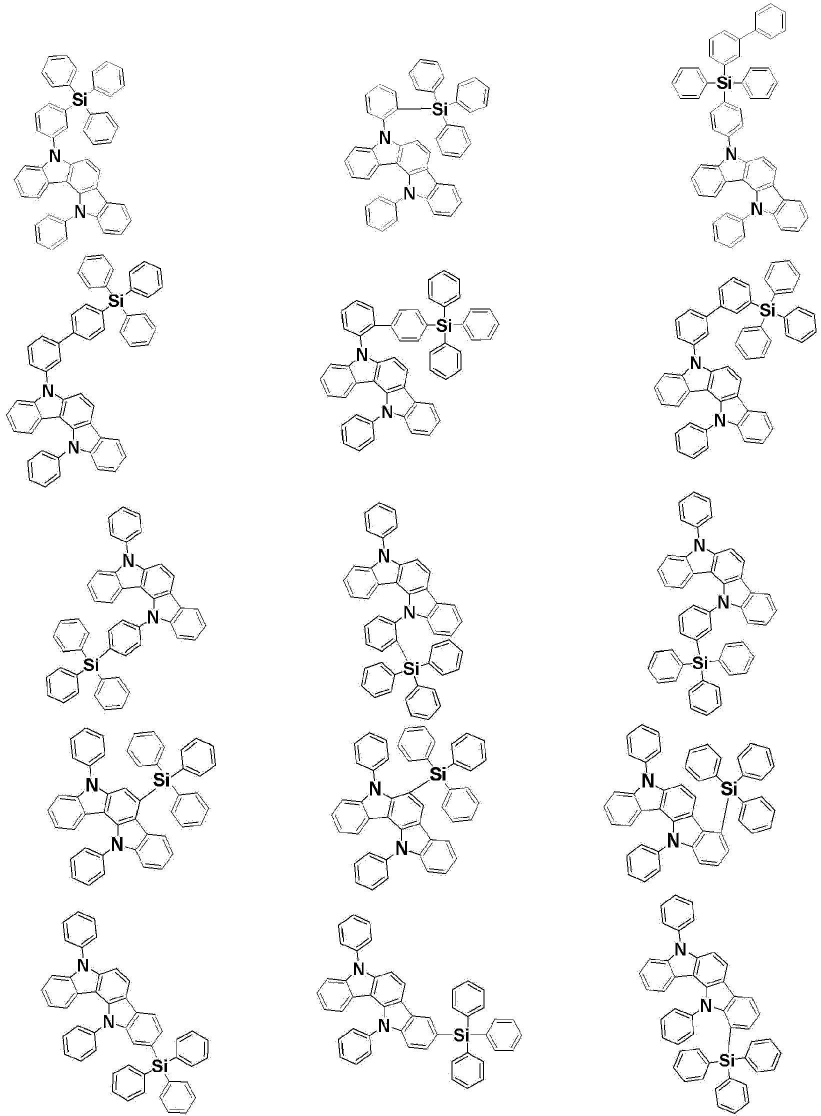

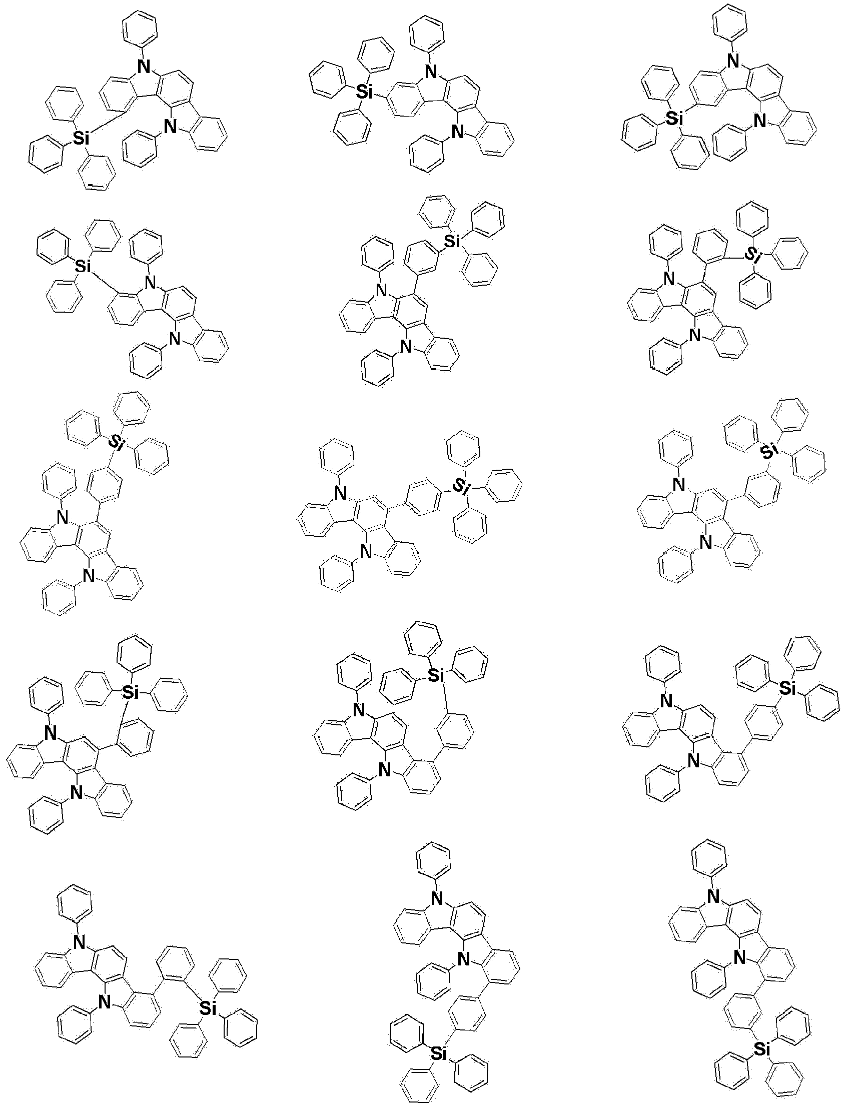

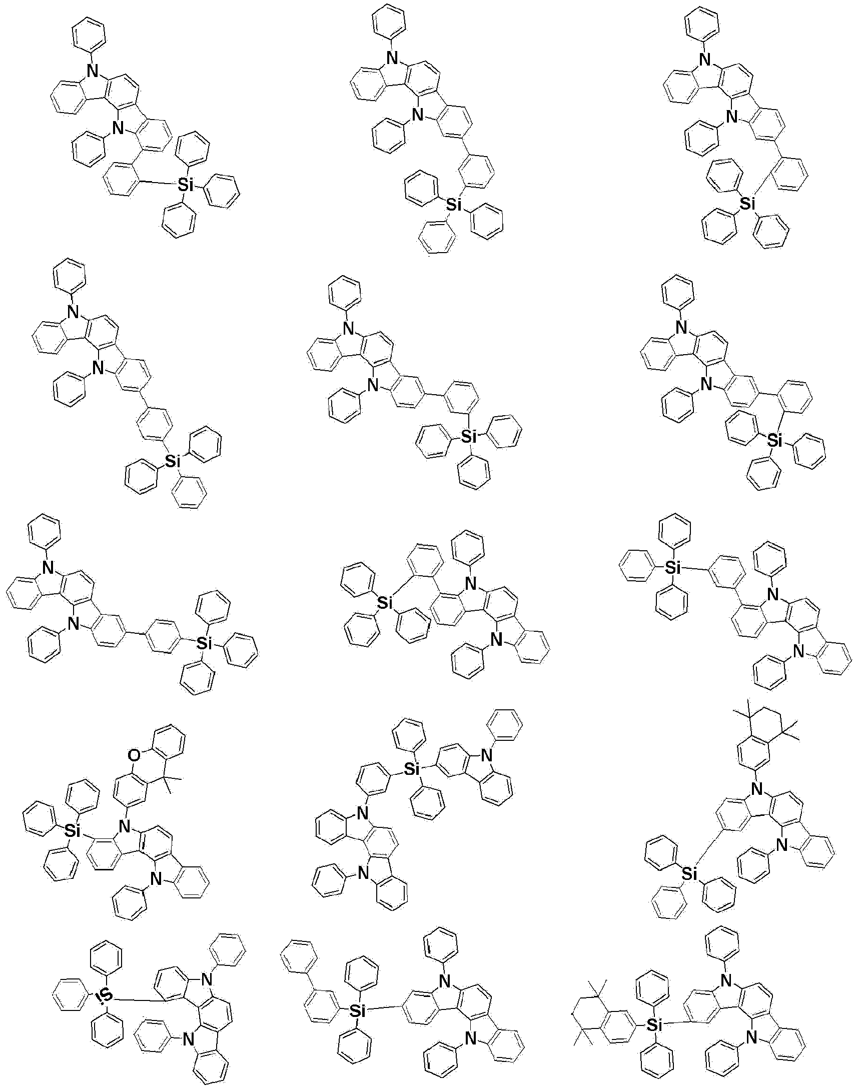

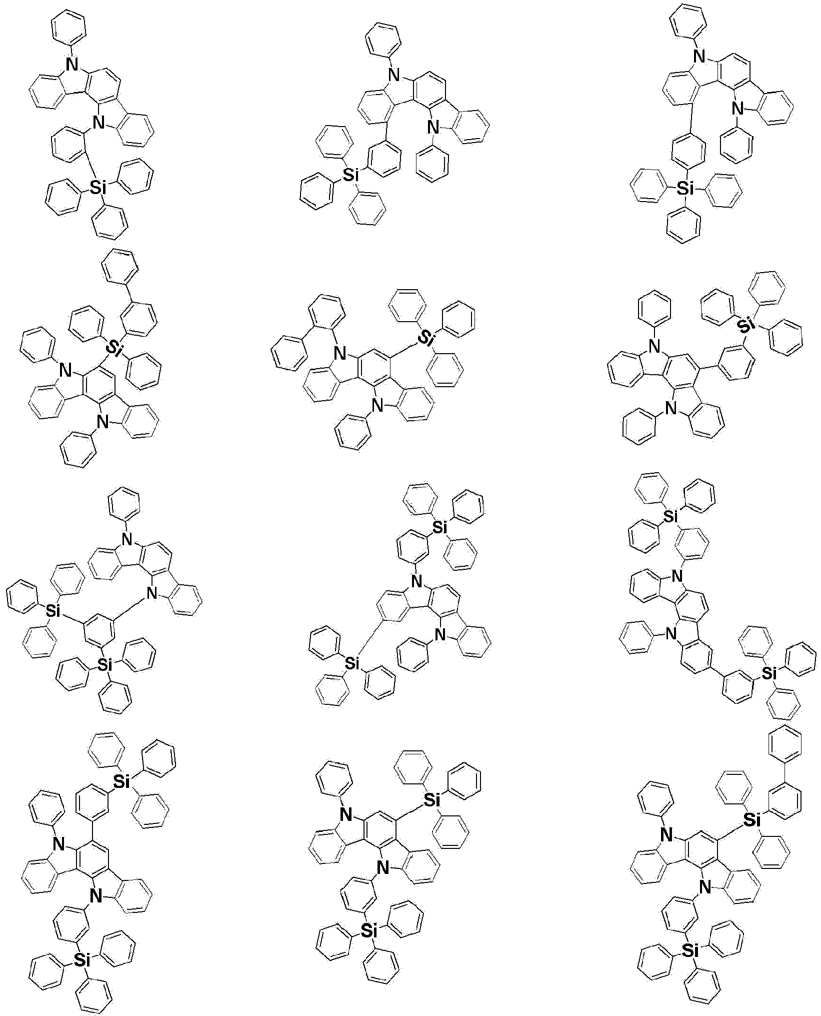

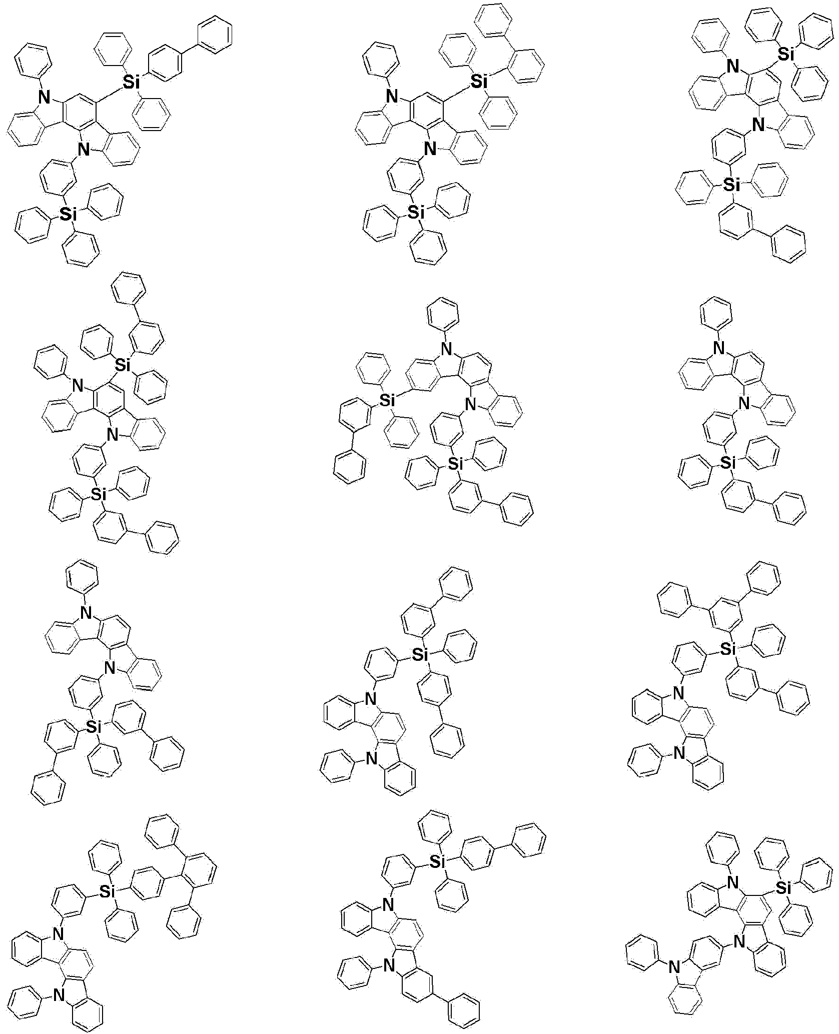

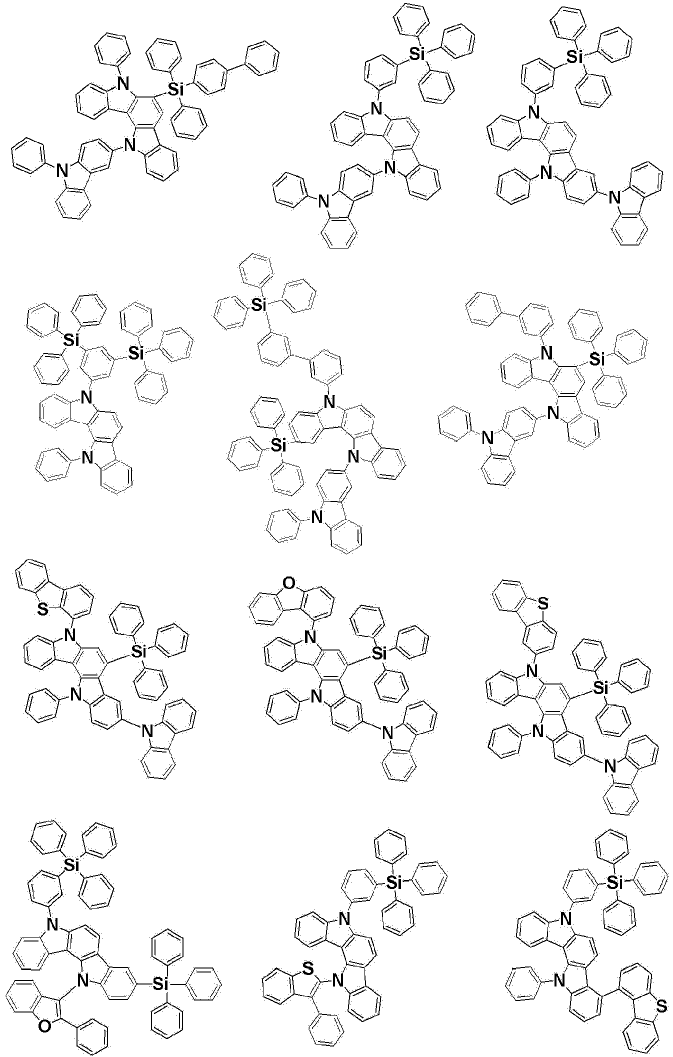

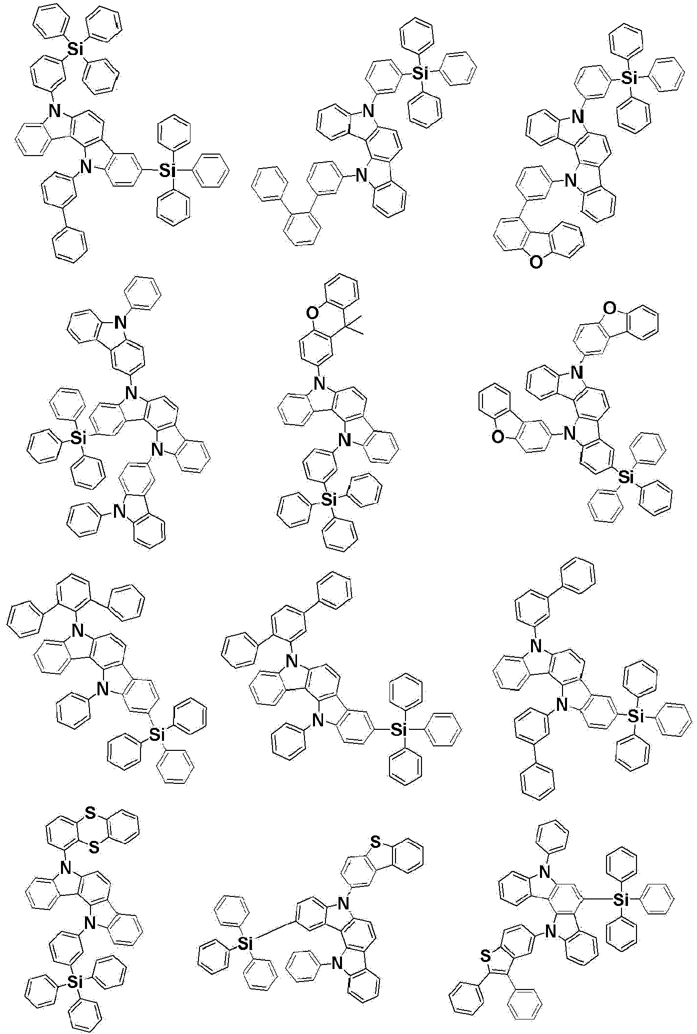

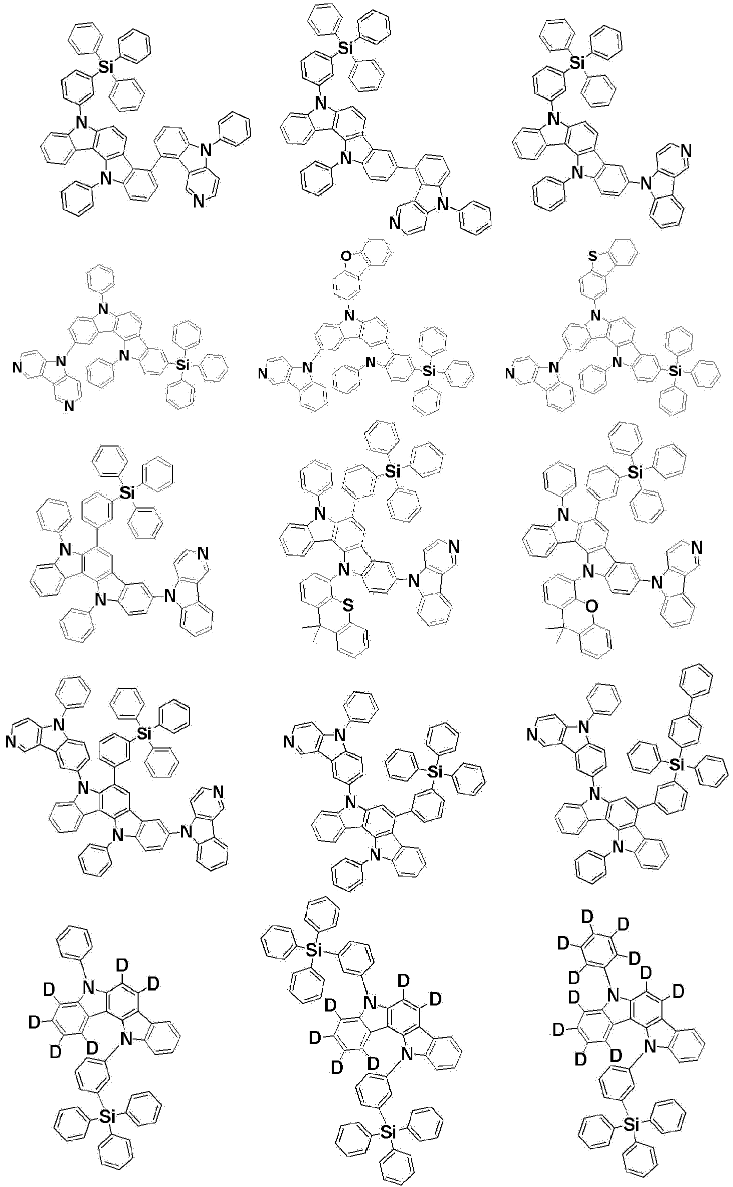

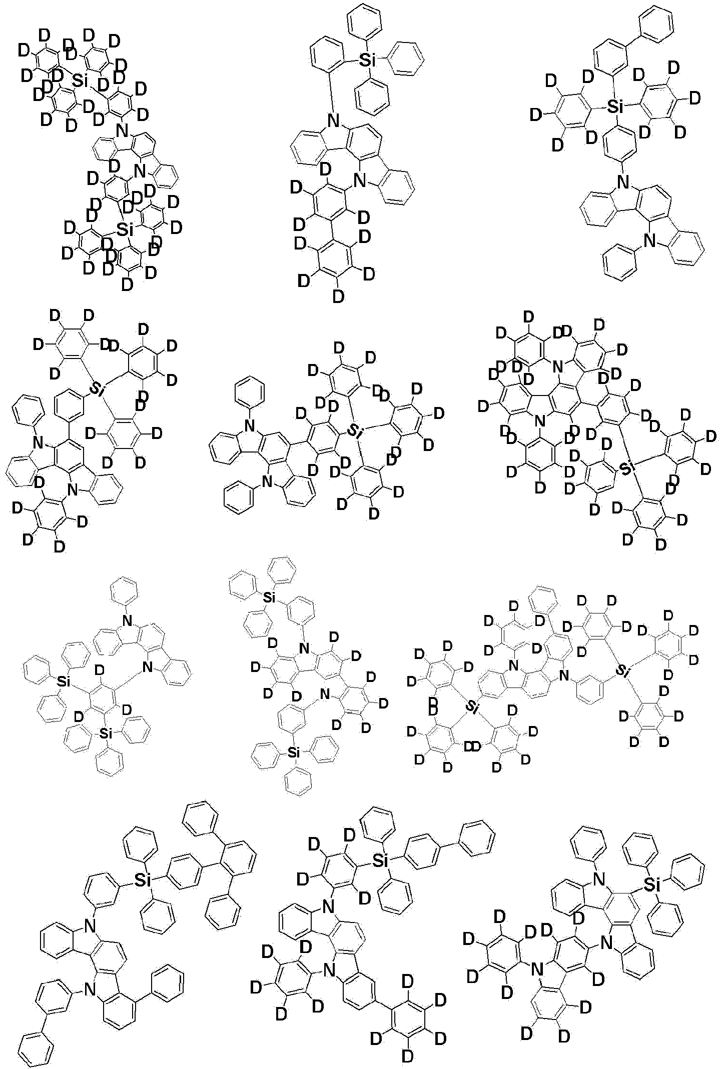

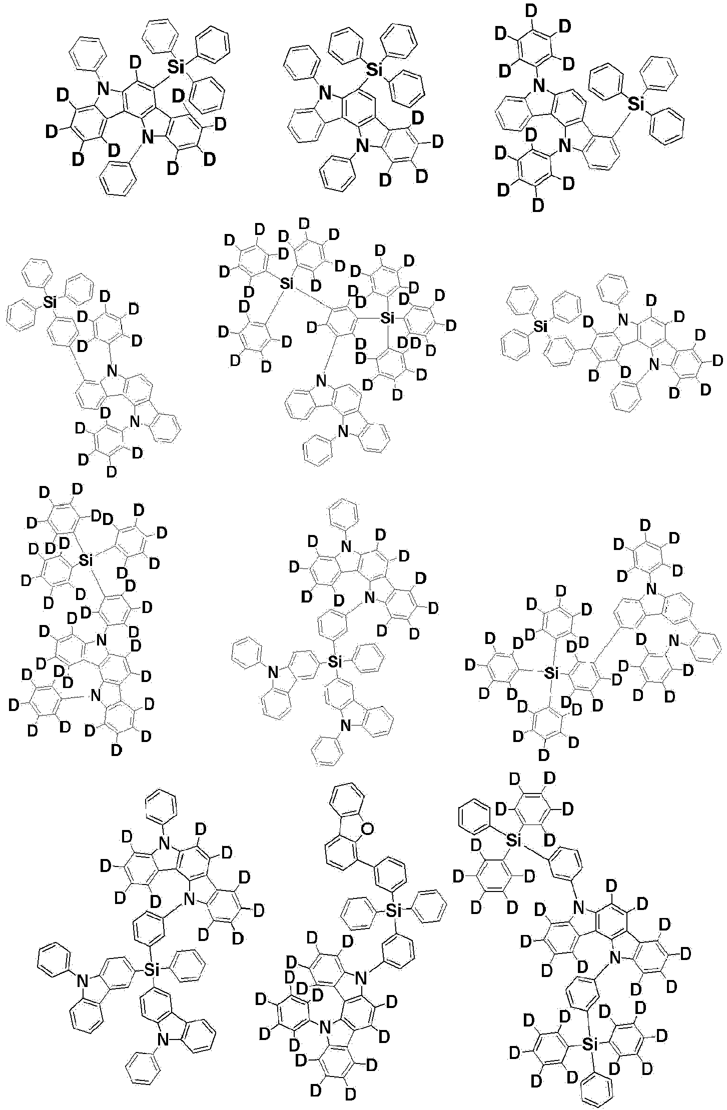

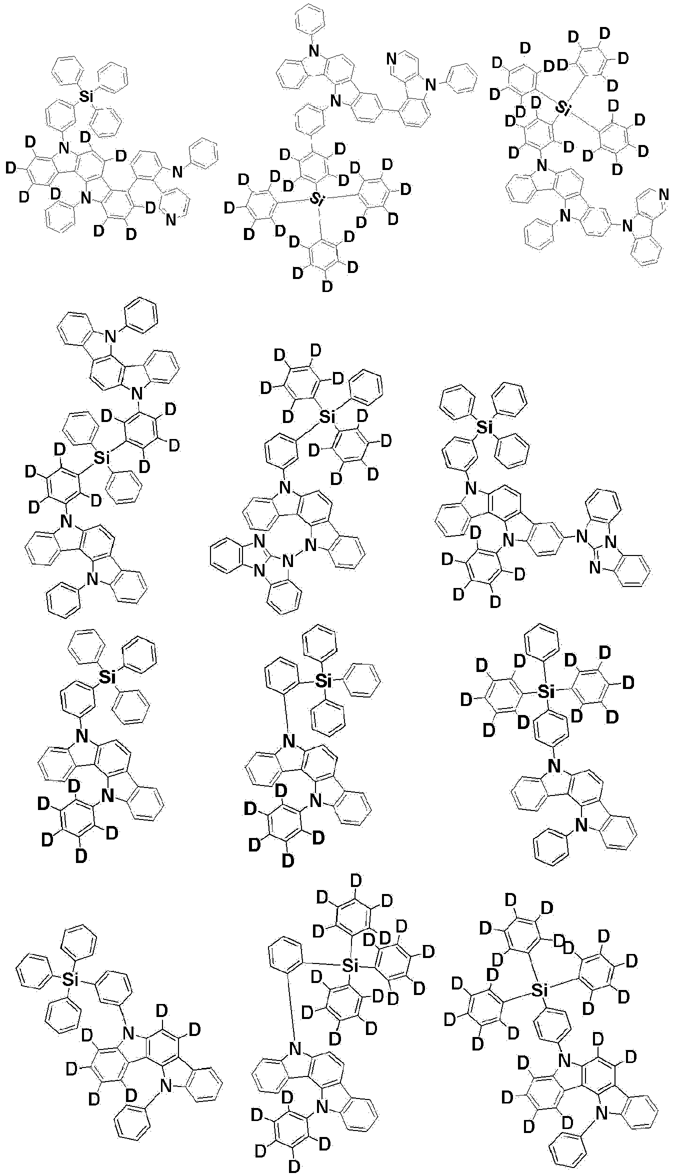

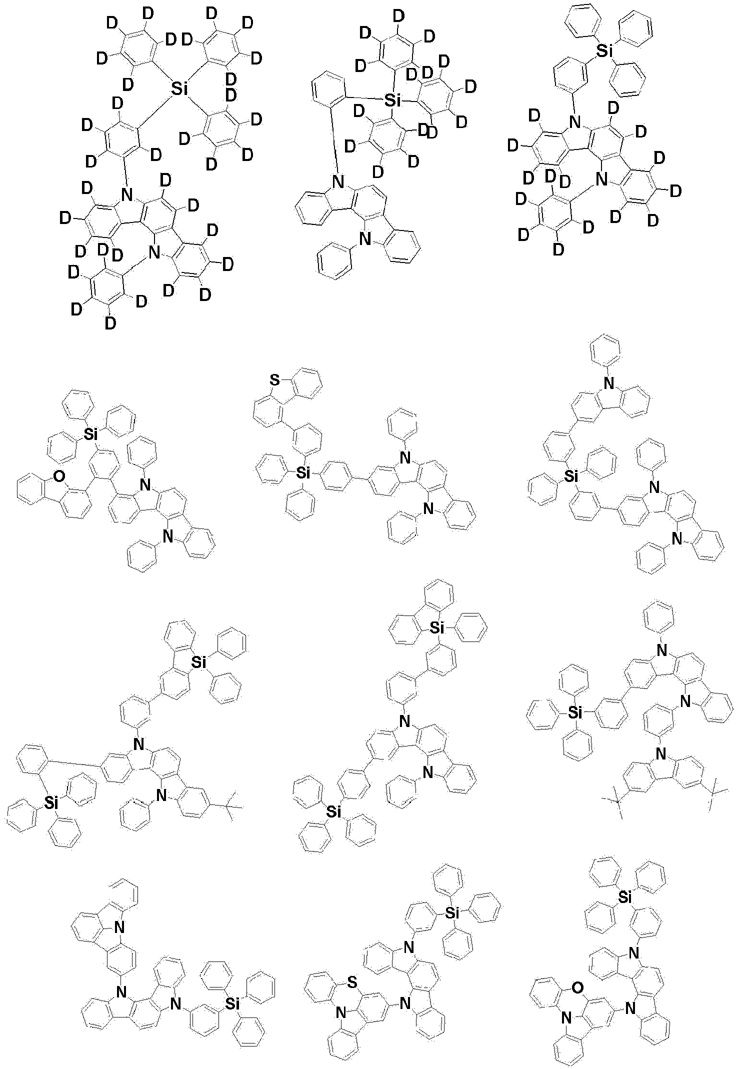

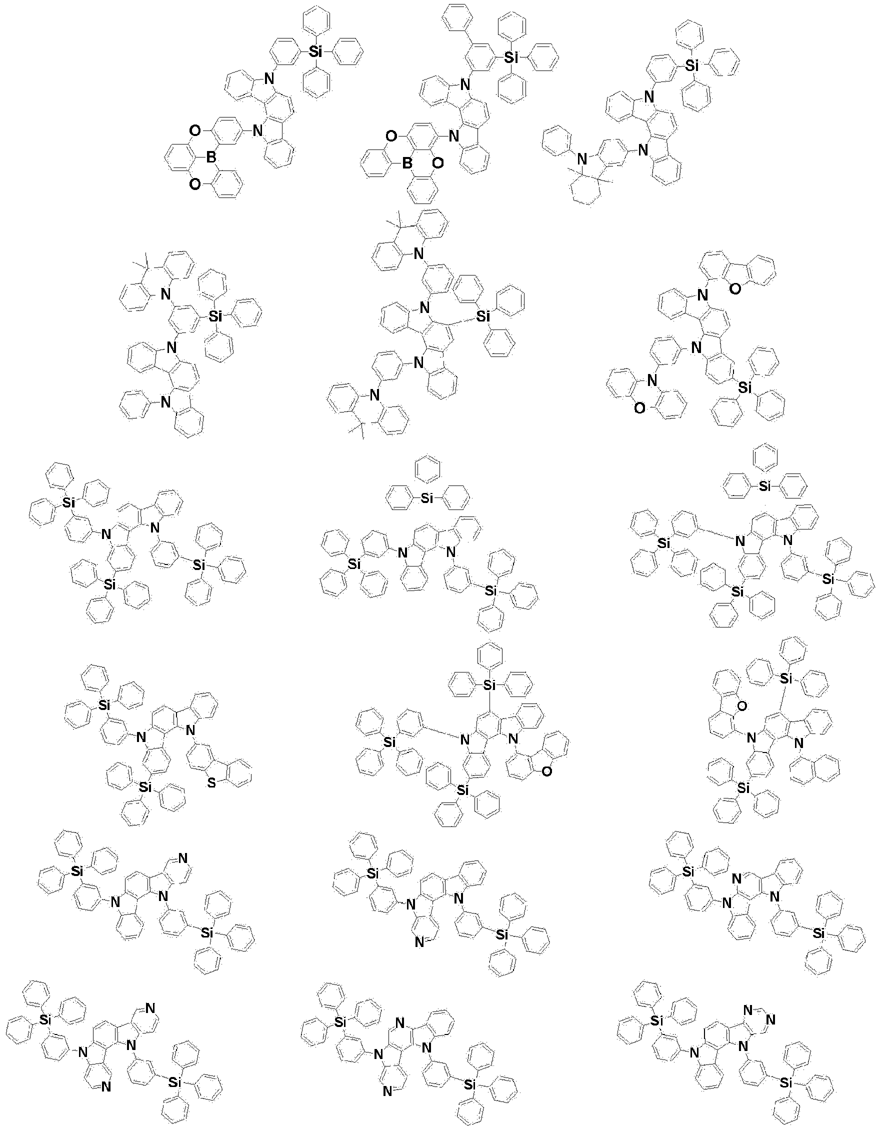

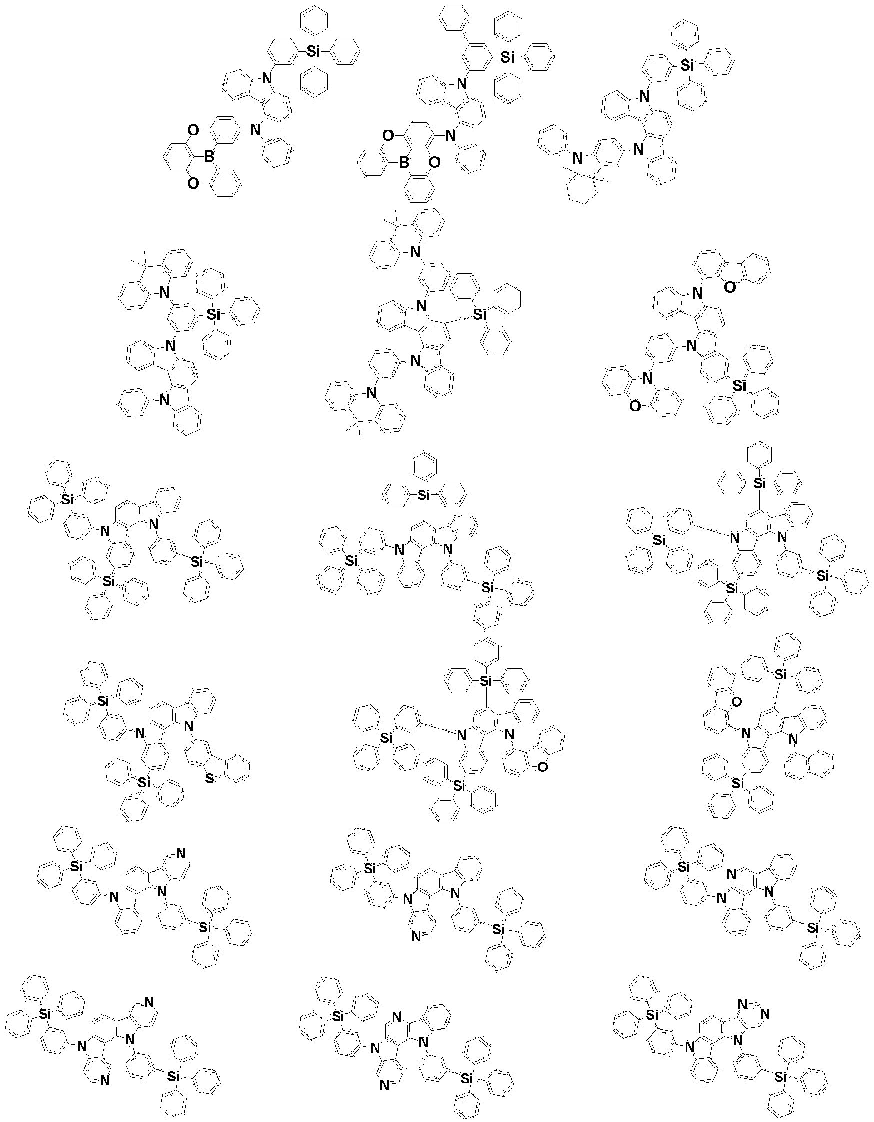

7. An organic light emitting device comprising a first electrode, a second electrode opposite to the first electrode, and one or more organic layers interposed between the first and second electrodes wherein one of the organic layers is a light emitting layer comprising a host and a dopant and the host comprises the compound represented by Formula 1 according to claim 1.

8. The organic light emitting device according to claim 7, wherein the light emitting layer further comprises one or more host compounds other than the organic compound represented by Formula 1 and wherein the two or more host compounds are mixed or stacked in the light emitting layer.

9. The organic light emitting device according to claim 7, wherein the organic compound represented by Formula 1 is used with an organic compound represented by Formula 2 or 3 as another host: 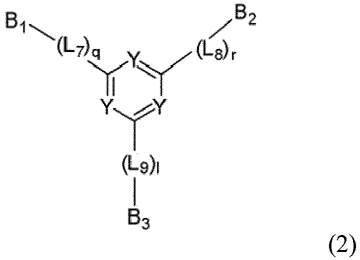 wherein the moieties Y are the same as or different from each other and are each independently N or CR₁₁, with the proviso that at least one of the moieties Y is N, the groups R₁₁ are the same as or different from each other and are each independently selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₅₀ cycloalkyl, substituted or unsubstituted C₂-C₅₀ heterocycloalkyl, substituted or unsubstituted C₂-C₅₀ heteroaryl, and cyclic groups in which a substituted or unsubstituted C₃-C₃₀ aliphatic ring and a C₅-C₃₀ aromatic ring are fused together, L₇ to L₉ are the same as or different from each other and each independently represent a single bond or are each independently selected from substituted or unsubstituted C₆-C₃₀ arylene, substituted or unsubstituted C₂-C₃₀ heteroarylene, and divalent cyclic groups in which a substituted or unsubstituted C₃-C₂₄ aliphatic ring and a C₅-C₂₄ aromatic ring are fused together, B₁ to B₃ are the same as or different from each other and are each independently selected from substituted or unsubstituted C₆-C₅₀ aryl, substituted or unsubstituted C₂-C₅₀ heteroaryl, and cyclic groups in which a substituted or unsubstituted C₃-C₃₀ aliphatic ring and a C₅-C₃₀ aromatic ring are fused together, substituted or unsubstituted C₁-C₃₀ amine, substituted or unsubstituted C₁-C₃₀ silyl, and substituted or unsubstituted C₁-C₃₀ germanium, and q, r, and 1 are integers of 1 or 2, provided that when q, r, and 1 are integers greater than or equal to 2, L₇ to L₉ are the same as or different from each other, respectively, 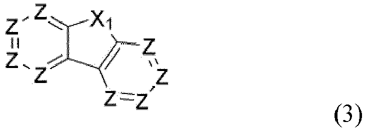 wherein the moieties Z are the same as or different from each other and are each independently N or CR₁₂, with the proviso that at least one of the moieties Z is N, X₁ is O, S, NR₁₃, CR₁₄R₁₅, SiR₁₆R₁₇ or GeR₁₈R₁₉, R₁₂ to R₁₉ are the same as or different from each other and are each independently selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₅₀ cycloalkyl, substituted or unsubstituted C₂-C₅₀ heterocycloalkyl, substituted or unsubstituted C₂-C₅₀ heteroaryl, and cyclic groups in which a substituted or unsubstituted C₃-C₃₀ aliphatic ring and a C₅-C₃₀ aromatic ring are fused together, with the proviso that adjacent ones of the groups R₁₂ are optionally linked to each other to form an alicyclic or aromatic monocyclic or polycyclic ring, R₁₄ and R₁₅ are optionally linked to each other to form an alicyclic or aromatic monocyclic or polycyclic ring, R₁₆ and R₁₇ are optionally linked to each other to form an alicyclic or aromatic monocyclic or polycyclic ring, and R₁₈ and R₁₉ are optionally linked to each other to form an alicyclic or aromatic monocyclic or polycyclic ring.

10. The organic light emitting device according to claim 9, wherein the organic compounds represented by Formulas 2 and 3 are selected from the following compounds:

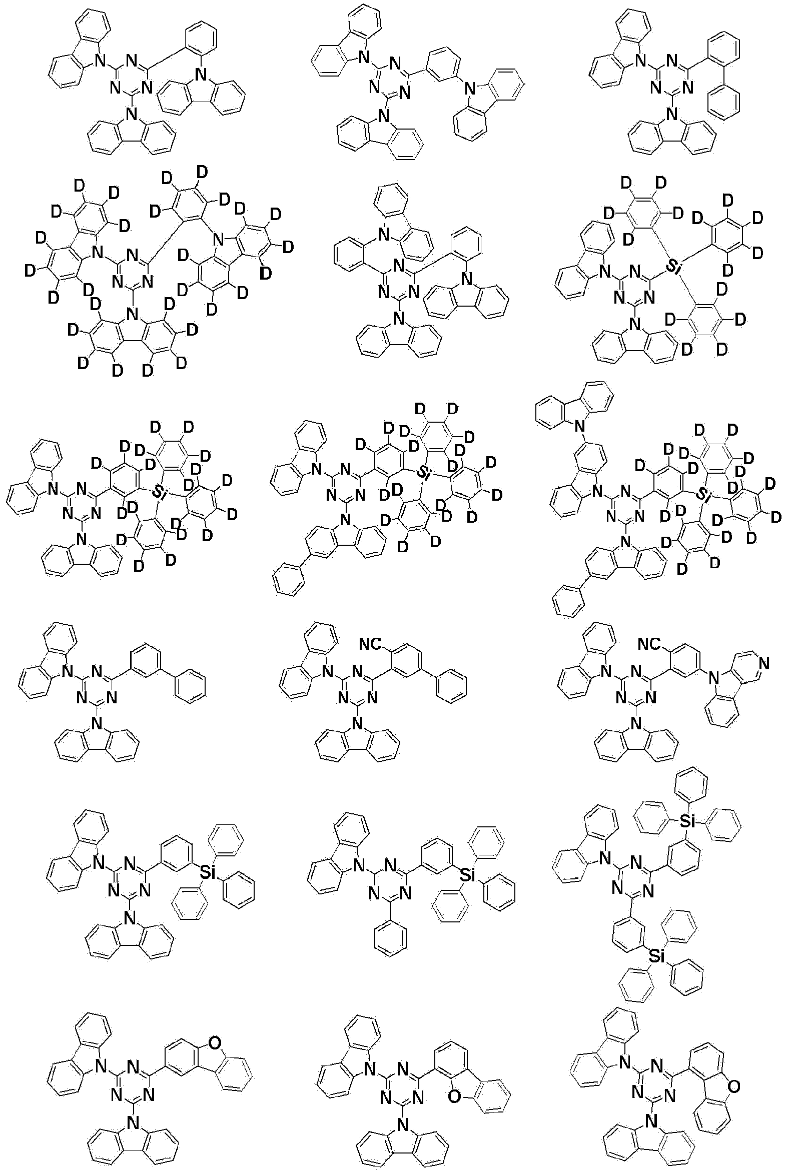

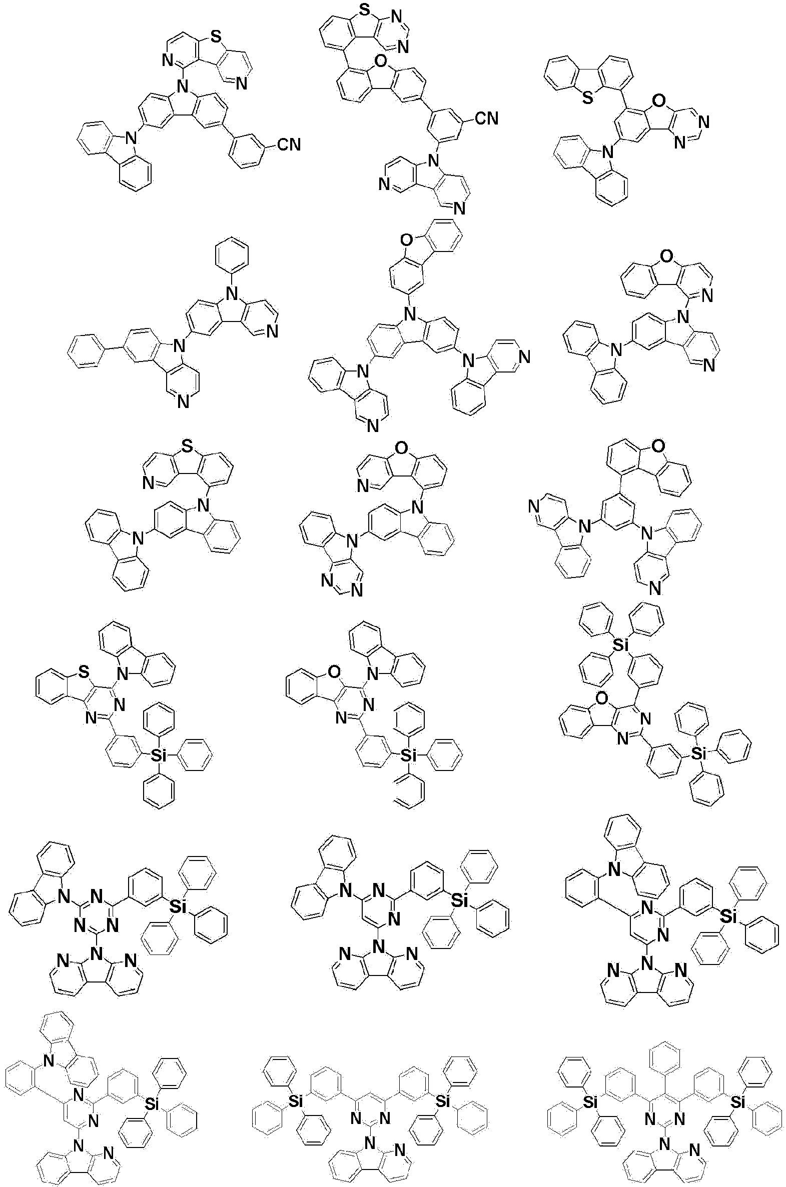

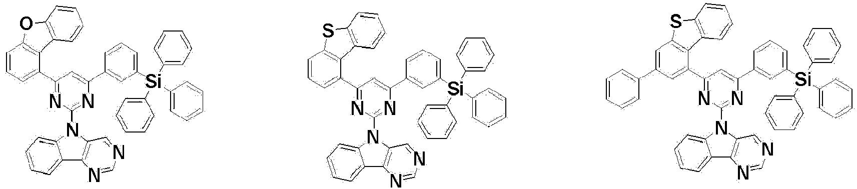

11. The organic light emitting device according to claim 7, wherein the organic compound represented by Formula 1 is used as a host that emits blue phosphorescence.

12. The organic light emitting device according to claim 7, wherein the dopant comprises at least one organometallic compound.

13. The organic light emitting device according to claim 12, wherein the light emitting layer further comprises one or more dopants other than the organometallic compound and wherein the two or more dopants are mixed or stacked in the light emitting layer.

14. The organic light emitting device according to claim 13, wherein one of the additional dopants is a polycyclic compound represented by Formula 4: 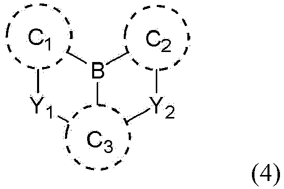 wherein Y₁ and Y₂ are the same as or different from each other and are each independently selected from O, S, NR₃₁, CR₃₂R₃₃, SiR₃₄R₃₅, and GeR₃₆R₃₇, C₁ to C₃ are the same as or different from each other and are each independently selected from substituted or unsubstituted C₆-C₃₀ aromatic hydrocarbon rings, substituted or unsubstituted C₃-C₃₀ aliphatic hydrocarbon rings, substituted or unsubstituted C₂-C₃₀ aromatic heterocyclic rings, substituted or unsubstituted C₂-C₃₀ aliphatic heterocyclic rings, and cyclic groups in which a substituted or unsubstituted C₃-C₂₄ aliphatic ring and a C₅-C₂₄ aromatic ring are fused together, R₃₁ to R₃₇ are the same as or different from each other and are each independently selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₅₀ cycloalkyl, substituted or unsubstituted C₂-C₅₀ heterocycloalkyl, substituted or unsubstituted C₂-C₅₀ heteroaryl, cyclic groups in which a substituted or unsubstituted C₃-C₃₀ aliphatic ring and a C₅-C₃₀ aromatic ring are fused together, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, substituted or unsubstituted germanium, nitro, cyano, and halogen, with the proviso that each of R₃₁ to R₃₇ is optionally linked to one or more of the C₁ to C₃ rings to form an alicyclic or aromatic monocyclic or polycyclic ring, R₃₂ and R₁₃ are optionally linked to each other to form an alicyclic or aromatic monocyclic or polycyclic ring, R₃₄ and R₃₅ are optionally linked to each other to form an alicyclic or aromatic monocyclic or polycyclic ring, and R₃₆ and R₃₇ are optionally linked to each other to form an alicyclic or aromatic monocyclic or polycyclic ring, the "substituted" in the definitions of Y₁, Y₂, and C₁ to C₃ in Formula 4 indicating substitution with one or more substituents selected from deuterium, C₁-C₂₄ alkyl, C₂-C₂₄ alkenyl, C₂-C₂₄ alkynyl, C₃-C₃₀ cycloalkyl, C₁-C₂₄ heteroalkyl, C₆-C₃₀ aryl, C₇-C₃₀ arylalkyl, C₇-C₃₀ alkylaryl, C₂-C₃₀ heteroaryl, C₂-C₃₀ heteroarylalkyl, cyclic groups in which a substituted or unsubstituted C₃-C₂₄ aliphatic ring and a C₅-C₂₄ aromatic ring are fused together, C₁-C₂₄ alkoxy, C₁-C₃₀ amine, C₁-C₃₀ silyl, C₁-C₃₀ germanium, C₆-C₂₄ aryloxy, C₆-C₂₄ arythionyl, cyano, halogen, hydroxyl, and nitro, or a combination thereof, provided that when substituted with two or more substituents, the substituents are identical to or different from each other, the "unsubstituted" in the same definition indicating having no substituent, and one or more hydrogen atoms in each of the substituents being optionally replaced by deuterium atoms.

15. The organic light emitting device according to claim 7, wherein the organic light emitting device is used in a display or lighting system selected from flat panel displays, flexible displays, monochromatic flat panel lighting systems, white flat panel lighting systems, flexible monochromatic lighting systems, flexible white lighting systems, displays for automotive applications, displays for virtual reality, and displays for augmented reality.
